(19) Europäisches Patentamt
European Patent Office
Office européen des brevets

(11) EP 2 728 639 B1

(12) # EUROPEAN PATENT SPECIFICATION

(45) Date of publication and mention of the grant of the patent:
**18.04.2018 Bulletin 2018/16**

(21) Application number: **12804612.5**

(22) Date of filing: **18.06.2012**

(51) Int Cl.:
***C07D 471/04*** (2006.01) ***C07F 15/00*** (2006.01)
***C09K 11/06*** (2006.01) ***H01L 51/50*** (2006.01)
***H01L 51/56*** (2006.01)

(86) International application number:
**PCT/JP2012/065471**

(87) International publication number:
**WO 2013/002051 (03.01.2013 Gazette 2013/01)**

(54) **ORGANIC ELECTROLUMINESCENT ELEMENT AND ITS MANUFACTURING METHOD**
ORGANISCHES ELEKTROLUMINESZENZELEMENT UND SEIN HERSTELLUNGSVERFAHREN
ÉLÉMENT ÉLECTROLUMINESCENT ORGANIQUE ET SON PROCÉDÉ DE FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.06.2011 JP 2011142425**

(43) Date of publication of application:
**07.05.2014 Bulletin 2014/19**

(73) Proprietor: **Konica Minolta, Inc.**
**Tokyo 100-7015 (JP)**

(72) Inventors:
- **OOHISA, Satoru**
  **Hino-shi**
  **Tokyo 191-8511 (JP)**
- **SUZURI, Yoshiyuki**
  **Hino-shi**
  **Tokyo 191-8511 (JP)**
- **OIKAWA, Kazuhiro**
  **Hachioji-shi**
  **Tokyo 192-8505 (JP)**
- **SATO, Shuri**
  **Hino-shi**
  **Tokyo 191-8511 (JP)**

(74) Representative: **Green, Mark Charles**
**Urquhart-Dykes & Lord LLP**
**Euston House**
**24 Eversholt Street**
**London NW1 1AD (GB)**

(56) References cited:

| | |
|---|---|
| **EP-A2- 1 220 339** | **WO-A1-2008/065975** |
| **JP-A- 2007 042 314** | **JP-A- 2008 140 620** |
| **JP-A- 2008 235 327** | **JP-A- 2010 067 960** |
| **JP-A- 2010 209 320** | **JP-A- 2010 212 675** |
| **JP-A- 2011 054 931** | **US-A1- 2003 080 338** |
| **US-A1- 2007 024 188** | **US-A1- 2011 068 331** |

- **CHOPRA N ET AL: "High-Efficiency Blue Emitting Phosphorescent OLEDs", IEEE TRANSACTIONS ON ELECTRON DEVICES, IEEE SERVICE CENTER, PISACATAWAY, NJ, US, vol. 57, no. 1, 24 November 2009 (2009-11-24), pages 101-107, XP011285318, ISSN: 0018-9383, DOI: 10.1109/TED.2009.2035028**
- **MASAYOSHI NOMURA ET AL: "Synthesis and Properties of Poly[di(1-naphthyl)-4-tolylamine] as a Hole Transport Material", MACROMOLECULES, vol. 37, no. 4, 24 January 2004 (2004-01-24), pages 1204-1210, XP055171799, ISSN: 0024-9297, DOI: 10.1021/ma0355709**
- **Lian Duan ET AL: "Solution processable small molecules for organic light-emitting diodes", Journal of Materials Chemistry, vol. 20, no. 31, 1 January 2010 (2010-01-01), page 6392, XP055127738, ISSN: 0959-9428, DOI: 10.1039/b926348a**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 728 639 B1

- Bellmann: "New Triarylamine-Containing Polymers as Hole Transport Materials in Organic Light-Emitting Diodes: Effect of Polymer Structure and Cross-Linking on Device Characteristics", , 30 April 1998 (1998-04-30), XP055030500, DOI: 10.1021/cm980030p Retrieved from the Internet: URL:http://pubs.acs.org/doi/pdf/10.1021/cm980030p [retrieved on 2012-06-20]

## Description

Title of the Invention: ORGANIC ELECTROLUMINESCENT ELEMENT

### Technical Field

The present invention relates to a method of manufacturing an organic electroluminescent element and to an organic electroluminescent element with improved power efficiency by virtue of low voltage, stability in a long-term driving and stability in a storage in high temperature.

### Background Art

In recent years, an organic electroluminescent element using an organic compound (s) (hereinafter also referred to as an "organic EL element" arbitrarily) has been highly expected for its applications to, for example, a large-sized full-color display element of solid-state light emission available at a low price and to writing light source arrays. Thus, research and development of such an organic electroluminescent element have been actively conducted.

An organic EL element is a thin all-solid-state element composed of a pair of an anode and cathode formed on/over a film and an organic functional layer provided between the anode and the cathode, and the organic functional layer which may consists of a single or multiple layers containing an organic light-emitting compound(s) and has a thickness of only about 0.1 pm. It is known that when a relatively low voltage of about 2 to 20 V is applied to such an organic EL element, electrons are injected from a cathode to an organic compound layer, and holes are injected from an anode to the organic compound layer; then these electrons and holes are recombined with each other in a light-emitting layer, and energy is released as light upon return of an electron energy level from a conduction band to a valence bond. This technique is expected for use in future flat displays and lighting devices.

In an organic EL element utilizing phosphorescence emission, which has been recently found, can achieve efficiency of light emission of about four times larger in principle than that of a conventional element utilizing fluorescence emission. Thus, research and development regarding layer configurations and electrodes of a light-emitting element utilizing phosphorescence emission, as well as developments of materials for an element utilizing phosphorescence emission, have been extensively conducted all over the world. In particular, as one of measures for preventing global warming, an organic EL element utilizing phosphorescence emission has begun to be considered to be applied to lighting devices, which currently consumes large part of energy that human consumes. Hence, an organic EL element utilizing phosphorescence emission is extensively studied for improving its efficiency and for decreasing costs for practical realization of a white light-emitting panel, which can be an alternative for conventional lighting devices.

A white light-emitting panel used for lighting is required to have high efficiency and long lifetime. Particularly as to length of lifetime, a white light-emitting panel is inferior to a fluorescent light and white light-emitting LED at present. Thus, various studies for achieving higher efficiency and longer lifetime have been conducted.

An organic EL element is generally formed by deposition. In deposition, however, it is difficult to reduce a cost because of a rate of forming a film, a material-use efficiency, use of a process in vacuum and the like.

Given this, experiments to form an organic EL element by application has actively conducted in recent years. Application is expected to reduce a cost because a rate of forming a film is short and a material-use efficiency is high in the case of application, compared to the case of deposition.

An organic EL element is normally composed of multiple layers. Thus, in the case of forming an organic EL element by application, an upper layer needs to be applied so as not to dissolve its base. IT is generally difficult to apply an upper layer without dissolving its base made of a low-molecular-weight compound(s). Therefore, it is often that materials used in application are high-molecular-weight materials.

However, purification of a high-molecular-weight material is difficult. In addition, a tiny amount of an impurity greatly influences performance. Thus, it is known that a low-molecular-weight material(s) is better to be used in a light-emitting layer which is significantly influenced.

In the case where a light-emitting layer consisting of a low-molecular-weight material(s) is stacked on a hole-transporting layer consisting of a high-molecular-weight material(s), it is known that the high-molecular-weight material(s) of the hole-transporting layer swells and the low-molecular-weight material(s) of the light-emitting layer intrude into the high-molecular-weight material (s) in applying the light-emitting layer to form a mixed region containing the materials of both of these layers at their interface (see Patent Documents 1 and 2, for example) . When such a mixed region is formed, an intermolecular interaction between these layers is facilitated and thus a required voltage can be low, which increases a power efficiency (efficiency of light emission).

However, when such a mixed region is formed, excitons are easy to diffuse into a hole-transporting layer (HTL), resulted in degradation of the HTL. Such a problem may be easy to occur especially in the case where a host and/or dopant having a T1 (excited triplet energy) higher than that of a HTL are used as materials of the light-emitting layer.

Thus, this technique is difficult to be used in a blue phosphorescent element. In Patent Document 1, a dopant used therein is fluorescent; on the other hand, if a phosphorescent dopant is used, an element is insulated from the influence of degradation of the HTL because a lifetime of light emission of a phosphorescent dopant is only in nanosecond time region. Patent Document 2 discloses a white light-emitting element, but $Ir(ppy)_3$ is used as a dopant, which emits near-green light and does not has a high T1.
EP1220339 describes a light emitting device which has a structure for lowering energy barriers at interfaces.
Chopra et *al.* (DOI: 10.1109/TED.2009.2035028) describes high-efficiency blue phosphorescent organic light emitting diodes. US2011/068331 describes an organic light emitting device with improved lifespan and reliability.
WO2008/065975 describes a light-emitting element having high emission efficiency and long lifetime.
Masayoshi et al. (DOI: 10.1021/ma0355709) describes poly[di(1-napthyl)-4-tolyamine] as a hole-transporting material.
JP 2008 235327 describes an organic electroluminescent device which comprises a luminous layer including a phosphorescent material; a hole block layer provided on the luminous layer; a functional layer made of not fewer than three organic layers containing the luminous layer and the hole block layer; and a pair of electrodes for clamping the functional layer . In the functional layer, mixed layers in which the organic materials of the organic layer are mixed are provided on the interface between the organic layers, excluding the interface between the luminous layer and the hole block layer.
Lian Duan et al "Solution processable small molecules for organic light-emitting diodes" Journal of Materials Chemistry, Vol.20, No. 31, pages 6392 (1 January 2010*)* describes solution processable small molecules for OLED's in comparison to OLED's based on vacuum deposited small molecules. The document describes pinhole-free films obtained by solution processing from different solvents and stable OLED's by solution processes by molecular modifications, process optimization and proper thermal treatment.
Bellmann et al "New triarylamine-containing polymers as hole transport materials..." Chem. Mater. 1998, 10, 1668 -1676 describes a series of cross-linkable polymeric hole transport materials comprising poly (norborenes) with pendant triarylamine groups

Additional Prior Art Documents

Patent Document

Patent Document 1: Japanese Patent Application Laid-Open Publication No. 2010-67960
Patent Document 2: Japanese Patent Application Laid-Open Publication No. 2007-42314

Summary of the Invention

Problem to be Solved by the Invention

As described above, there has been no case where low voltage and long lifetime are accomplished by utilizing an interface mixing in a system containing a blue phosphorescent dopant(s) having a high T1.
Thus, a main object of the present invention is to provide an organic EL element containing a blue phosphorescent dopant(s) as a material(s) which constitute the light-emitting layer, the organic EL element achieving a high power efficiency by virtue of low voltage, being excellent in stability in a long-term driving and suppressing a change in chromaticity after a storage in high temperature.

Means for Solving Problem

According to the present invention, there is provided a method of manufacturing an organic electroluminescent element in accordance with Claim 1 of the present document. An organic electroluminescent element in accordance with Claim 10 is also provided.

Effect of the Invention

According to the present invention, the organic EL element achieving a high power efficiency by virtue of low voltage, being excellent in stability in a long-term driving and suppressing a change in chromaticity after a storage in high temperature can be provided, even the organic EL element contains a blue phosphorescent dopant(s) as a material(s) of the light-emitting layer(s).

Brief Description of Drawing

[Fig. 1] This is a cross-sectional view illustrating a schematic configuration of an organic electroluminescent element.

Embodiment for Carrying out the Invention

Preferred embodiments of the present invention will now be described referring to the drawing.

<<Configuration of Organic EL>>

As illustrated in Fig. 1, an organic electroluminescent element 100 according to a preferred embodiment of the present invention (hereinafter referred to as an "organic EL element") includes a flexible supporting substrate 1; on the flexible supporting substrate 1, an anode 2 is formed; on the anode 2, an organic functional layer 20 is formed; and on the organic functional layer 20, a cathode 9 is formed.
The organic functional layer 20 composed of layers provided between the anode 2 and the cathode 9, which layers constitute the organic electroluminescent element.
The organic functional layer 20 includes, for example, a hole-injecting layer 3, a hole-transporting layer 4, a mixed layer 5, a light-emitting layer 6, an electron-transporting layer 7 and an electron-injecting layer 8; the organic functional layer may further include a hole-blocking layer, an electron-blocking layer and the like.
The anode 2, the organic functional layer 20 and the cathode 9 on/over the flexible supporting substrate 1 are sealed with a flexible sealing member 11 using a sealing adhesive 10.
The above layer structure of the organic EL element 100 (see Fig. 1) is merely a preferred example, and the present invention is not limited thereto.
The organic EL element 100 of the present invention may have, for example, either of the following layer structures (i) to (viii):

(i) flexible supporting substrate/anode/light-emitting layer/electron-transporting layer/cathode/heat-conducting layer/sealing adhesive/sealing member
(ii) flexible supporting substrate/anode/hole-transporting layer/mixed layer/light-emitting layer/electron-transporting layer/cathode/heat-conducting layer/sealing adhesive/sealing member
(iii) flexible supporting substrate/anode/hole-transporting layer/mixed layer/light-emitting layer/hole-blocking layer/electron-transporting layer/cathode/heat-conducting layer/sealing adhesive/sealing member
(iv) flexible supporting substrate/anode/hole-transporting layer/mixed layer/light-emitting layer/hole-blocking layer/electron-transporting layer/cathode buffer layer/cathode/heat-conducting layer/sealing adhesive/sealing member
(v) flexible supporting substrate/anode/anode buffer layer/hole-transporting layer/mixed layer/light-emitting layer/hole-blocking layer/electron-transporting layer/cathode buffer layer/cathode/heat-conducting layer/sealing adhesive/sealing member
(vi) glass supporting body/anode/hole-injecting layer/light-emitting layer/electron-injecting layer/cathode/sealing member
(vii) glass supporting body/anode/hole-injecting layer/hole-transporting layer/mixed layer/light-emitting layer/electron-injecting layer/cathode/sealing member
(viii) glass supporting body/anode/hole-injecting layer/hole-transporting layer/mixed layer/light-emitting layer/electron-transporting layer/electron-injecting layer/cathode/sealing member

<<Organic Functional Layer 20 of Organic EL Element>>

The organic functional layer 20 of the organic EL element of the present invention will now be described in detail.

(1) Injecting Layer: Hole-Injecting Layer 3 and Electron-Injecting Layer 8

In the organic EL element of the present invention, an injecting layer(s) may be provided as needed. The injecting layer is categorized into an electron-injecting layer and a hole-injecting layer. The injecting layer may be provided between the anode and the light-emitting layer or between the anode and the electron hole-transporting layer, or between the cathode and the light-emitting layer or between the cathode and the electron-transporting layer, as described above.
The injecting layer of the present invention is a layer provided between the electrode and the organic functional layer to lower driving voltage and improve luminance, and described in detail in Chapter 2 "Electrode Materials" (pp. 123-166) of Div. 2 Chapter 2 of Organic EL element and its frontier of industrialization (published on November 30, 1998

by NTS Corporation). The injecting layer is categorized into an electron-injecting layer and electron hole-injecting layer.

Details of the electron hole-injecting layer are also described in, for example, Japanese Patent Application Laid-Open Publications Nos. Hei9-45479, Hei9-260062 and Hei8-288069. Examples of employable hole-injecting materials of the electron hole-injecting layer include polymers or aniline copolymers containing a triazole derivative(s), oxadiazole derivative (s), imidazole derivative (s), pyrazoline derivative(s), pyrazolone derivative(s), phenylenediamine derivative(s), arylamine derivative(s), amino-substituted chalcone derivative(s), oxazole derivatives(s), styrylanthracene derivative(s), fluorenone derivative(s), hydrazone derivative(s) stilbene derivative(s) and/or silazane derivative(s); polyarylalkane derivatives; and electroconductive polymers. Polythiophene derivatives, polyaniline derivatives and polypyrrole derivatives are preferable, and polythiophene derivatives are more preferable.

Details of the electron-injecting layer are also described in, for example, Japanese Patent Application Laid-Open Publications Nos. Hei6-325871, Hei9-17574 and Hei10-74586, and is specifically exemplified by a buffer layer composed of a metal as typified by strontium, aluminum and the like, a buffer layer composed of an alkali metal (s) as typified by lithium fluoride, a buffer layer composed of an alkali earth metal(s) as typified by magnesium fluoride, a buffer layer composed of an oxide(s) as typified by aluminum oxide. In the present invention, the buffer layer (i.e., injecting layer) is preferably a very thin layer and is preferably composed of potassium fluoride or sodium fluoride. The thickness of the injecting layer is about 0.1 nm to 5 $\mu$m, preferably 0.1 to 100 nm, more preferably 0.5 to 10 nm, and most preferably 0.5 to 4 nm.

(2) Hole-Transporting Layer 4

A hole-transporting material which constitutes the hole-transporting layer may be a compound employed in the hole-injecting layer. The hole-transporting material is preferably a porphyrin compound, aromatic tertiary amine compound or stylylamine compound, and more preferably an aromatic tertiary amine compound.

Representative examples of the aromatic tertiary anime compounds and stylylamine compounds include N,N,N',N'-tetraphenyl-4,4'-diaminophenyl; N,N'-diphenyl-N,N'-bis(3-methylphenyl)-[1,1'-biphenyl]-4,4' -diamine (TPD); 2,2-bis(4-di-*p*-tolylaminophenyl)propane; 1,1-bis(4-di-*p*-tolylaminophenyl)cyclohexane; N,N,N',N'-tetra-*p*-tolyl-4,4'-diaminobiphenyl; 1,1-bis(4-di-*p*-tolylaminophenyl)-4-phenylcyclohexane; bis(4-dimethylamino-2-methylphenyl)phenylmethane; bis(4-di-*p*-tolylaminophenyl)phenylmethane; N,N'-diphenyl-N,N'-di(4-methoxyphenyl)-4,4'-diaminobiphenyl ; N,N,N',N'-tetraphenyl-4,4'-diaminodiphenyl ether; 4,4'-bis(diphenylamino)quaterphenyl; N,N,N-tri(*p*-tolyl)amine, 4-(di-p-tolylamino)-4'-[4-(di-*p*-tolylamino)styryl]stilbene ; 4-N,N-diphenylamino-(2-diphenylvinyl)benzene; 3-methoxy-4'-N,N-diphenylaminostylbenzene; N-phenylcarbazole; a compound containing two fused aromatic rings in its molecule described in U.S. Patent No. 5,061,569 such as 4,4'-bis[N-(1-naphthyl)-N-phenylamino]biphenyl (NPD); and a compound described in Japanese Patent Application Laid-Open Publication No. Hei4-308688, i.e., 4,4',4' '-tris[N-(3-methylphenyl)-N-phenylaminoltriphenylami ne (MTDATA) in which three triphenylamine units are linked together in a starburst form.

Polymer materials where the above compound(s) are introduced in their polymer chains or are present as their main chains may also be used. Further, inorganic compounds such as p-Si and p-SiC may also be used as a hole-injecting material or a hole-transporting material. In the present invention, a light-emitting layer is applied on the hole-transporting layer as an upper layer of the hole-transporting layer; thus, these high-molecular-weight materials are preferably used.

Still further, a hole-transporting material having properties like those of p-type semiconductors, as described in Japanese Patent Application Laid-Open Publications Nos. Hei4-297076, 2000-196140 and 2001-102175, J. Appl. Phys., 95, 5773 (2004), Japanese Patent Application Laid-Open Publication No. Hei11-251067, J. Huang et al. (Applied Physics Letters 80 (2002), p. 139) and Japanese Patent Application Laid-Open Publication No. 2003-519432, may also be used.

The hole-transporting layer may be obtained by forming a thin layer with the above-described hole-transporting material(s) by a known method such as vacuum deposition, spin coating, casting, printing such as ink jetting or LB method. The thickness of the hole-transporting layer is not particularly limited, but normally from about 5 nm to 5 $\mu$m, and preferably from 5 to 200 nm. The hole-transporting layer may consist of a single layer containing one or more of the above materials.

Preferable examples (1) to (60) of the hole-transporting material will now be described below, but the present invention is not limited thereto.

[Chemical Formula 1]

(1) 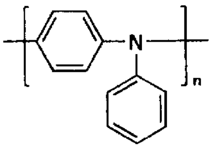

(2) 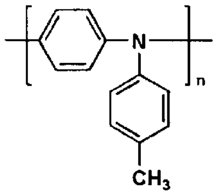

(3) 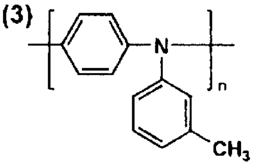

(4) 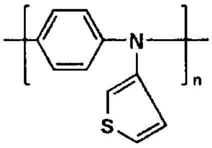

(5) 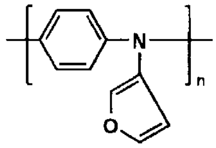

(6) 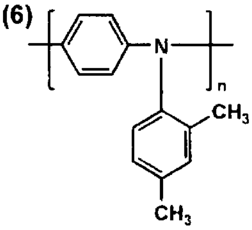

(7) 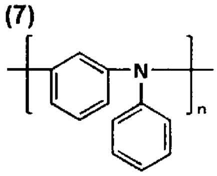

(8) 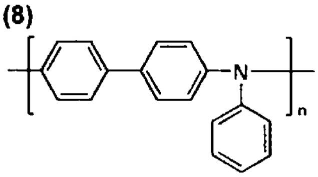

(9) 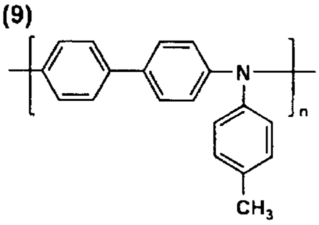

(10) 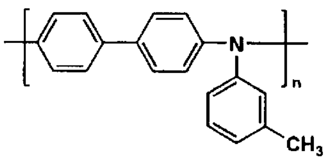

(11) 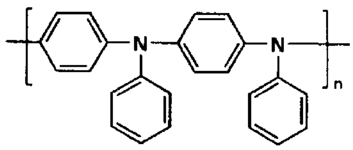

(12) 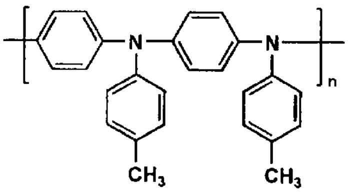

(13) 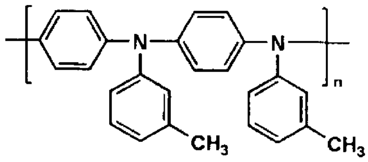

(14) 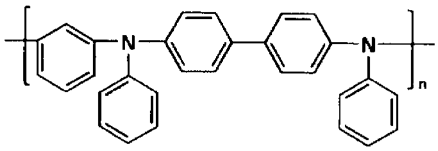

(15) 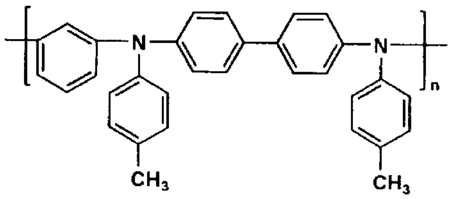

[Chemical Formula 2]

(16)

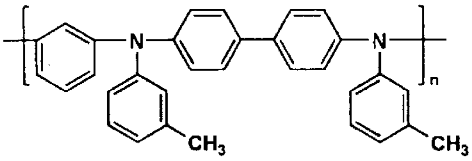

(17)

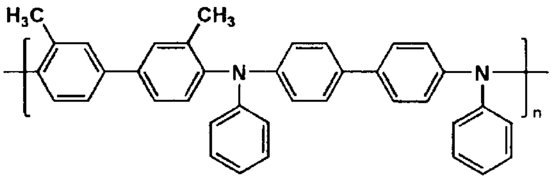

(18)

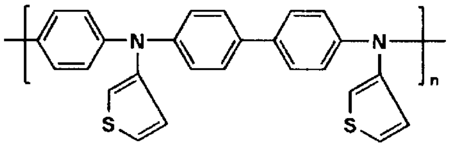

(19)

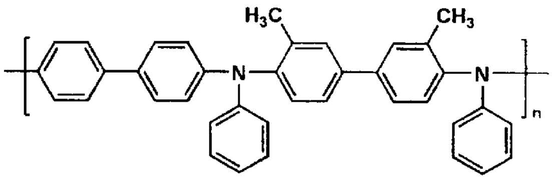

(20)

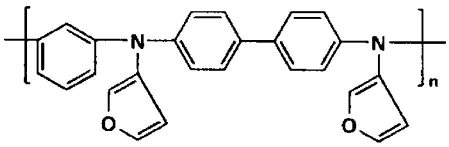

(21)

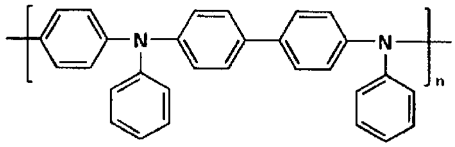

(22)

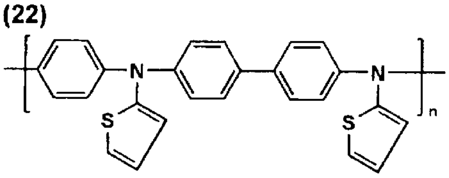

(23)

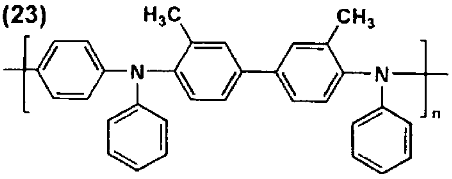

(24)

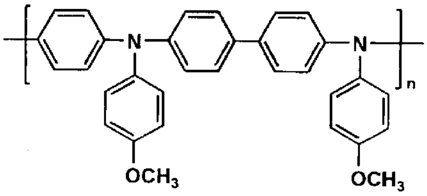

(25)

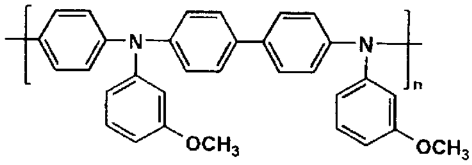

[Chemical Formula 3]

(26)

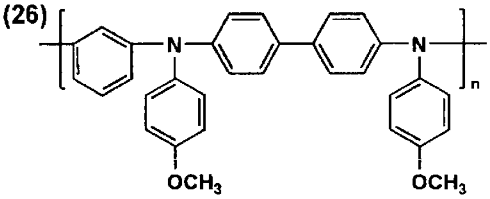

(27)

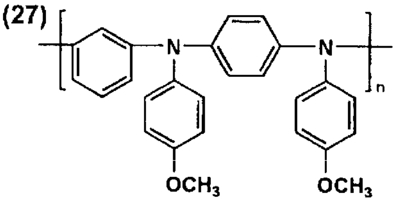

(28)

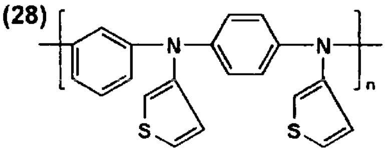

(29)

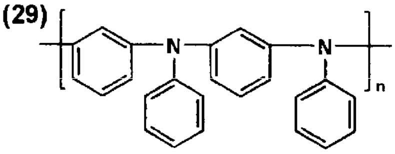

(30)

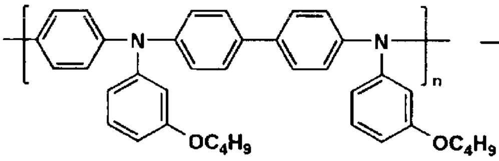

(31)

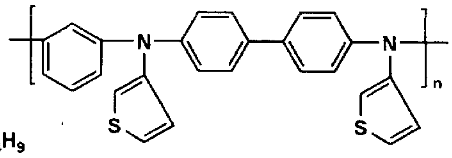

(32)

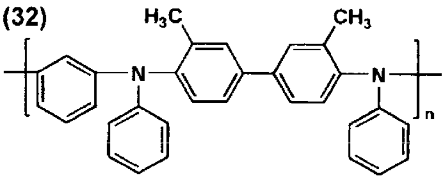

(33)

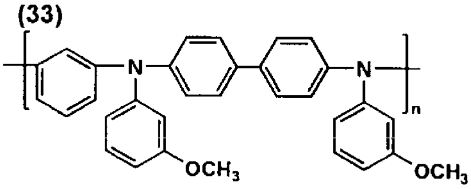

(34)

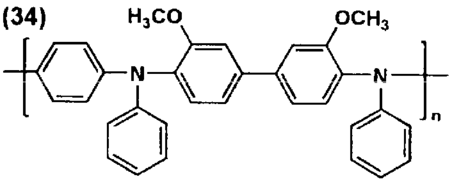

(35)

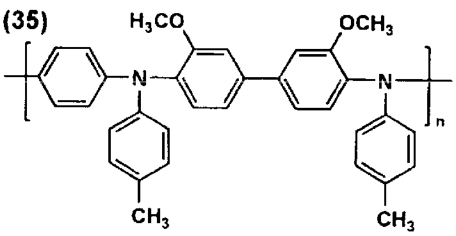

[Chemical Formula 4]

(36)

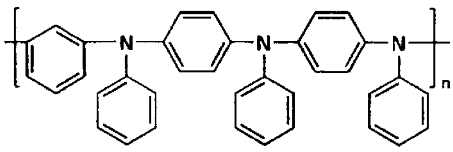

(37)

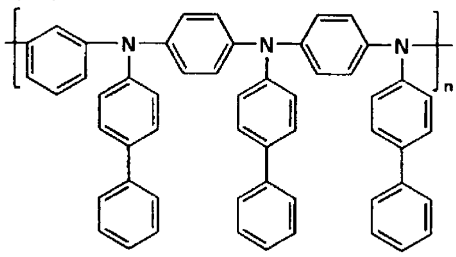

(38)

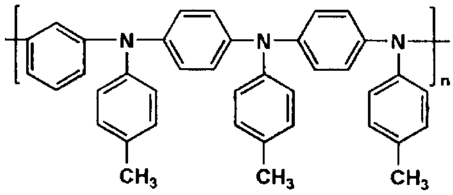

(39)

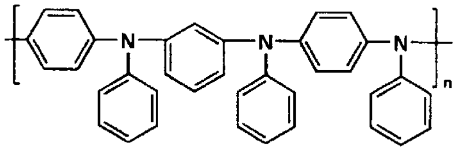

(40)

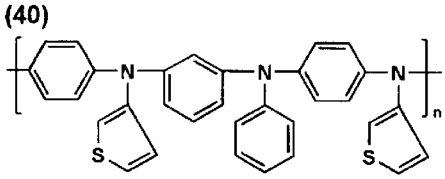

(41)

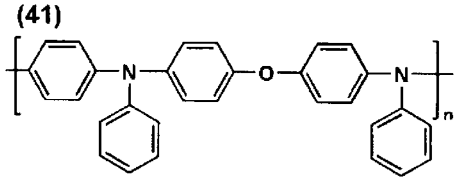

(42)

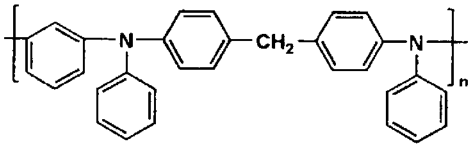

(43)

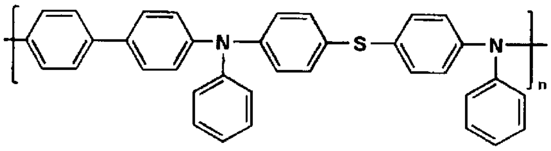

(44)

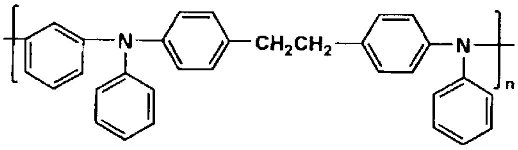

[Chemical Formula 5]

(45)

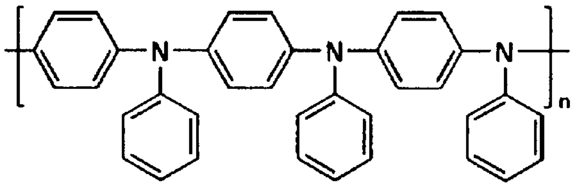

(46)

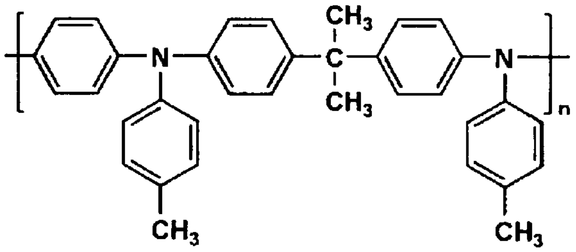

(47)

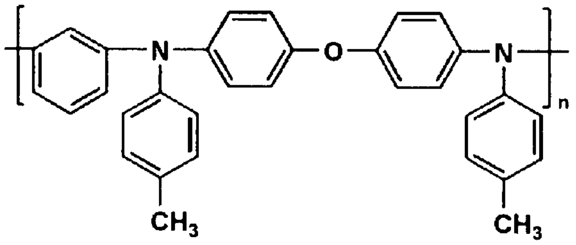

(48)

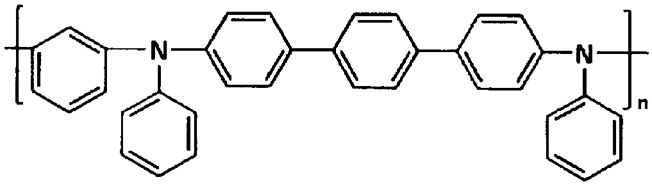

[Chemical Formula 6]

(49)

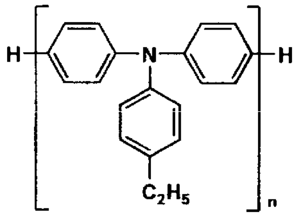

(50)

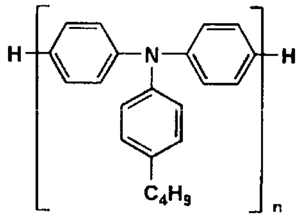

(51)

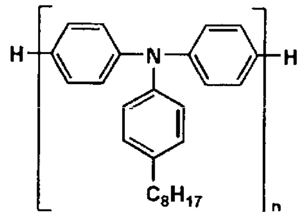

(52)

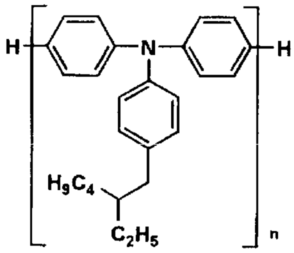

(53)

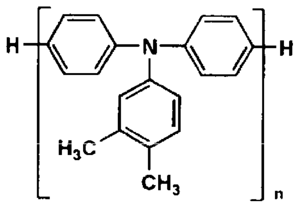

(54)

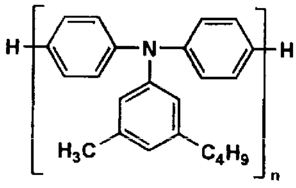

(55)

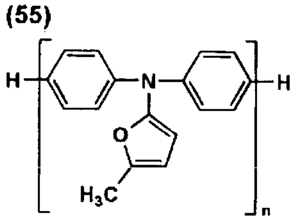

(56)

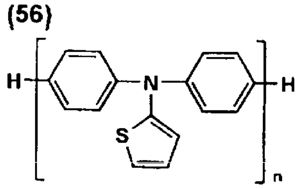

(57)

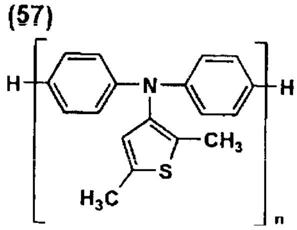

(58)

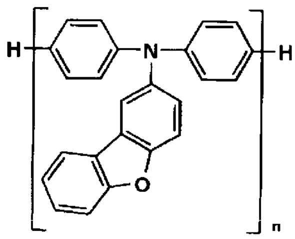

(59)

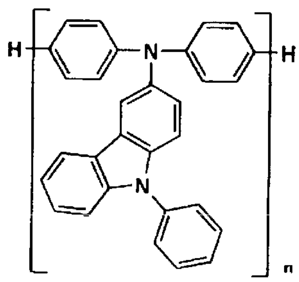

(60)

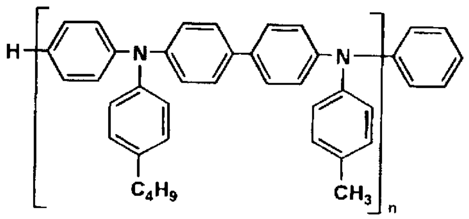

In the above exemplified compounds, n represents a degree of polymerization; n represents an integer so that a weight-average molecular weight is 60,000 to 100,000. It is preferable that a weight-average molecular weight is within the above range because layers can be formed without difficulties and desired effects on, for example, a power efficiency by virtue of low voltage are achieved.

These polymer compounds can be synthesized by a known method described in Makromol. Chem., 193, p.909 (1992), for example.

(3) Electron-Transporting Layer 7

The electron-transporting layer is composed of a material(s) having electron-transporting properties, and in a broad sense, includes an electron-injecting layer and a hole-blocking layer. One or more electron-transporting layers may be provided. For example, a combination of a hole-blocking layer and an electron-transporting layer may be employed.

Heretofore, in the case of providing a single or multiple electron-transporting layers, an electron-transporting material (also used as a hole-blocking material) used in the electron-transporting layer that is adjacent to the light-emitting

layer on the side of the cathode may be any material having properties for transporting electrons injected from the cathode to the light-emitting layer, and may be selected from conventionally known compounds such as metal complexes, namely, metal complexes of fluorene derivatives, carbazole derivatives, azacarbazole derivatives, oxadiazole derivatives, triazole derivatives, silole derivatives, pyridine derivatives, pyrimidine derivatives, 8-quinolinole derivatives, for example.

In addition, metal-free or metalphthalocyanine, or metal-free or metalphthalocyanine whose end (s) are substituted with an alkyl group (s), sulfonic acid group (s) or the like may be suitably used as the electron-transporting material.

Among them, carbazole derivatives, azacarbazole derivatives, pyridine derivatives are preferable, and azacarbazole derivatives are more preferable for the present invention.

The electron-transporting layer may be obtained by forming a thin layer with the above-described electron-transporting material(s) by a known method such as spin coating, casting, printing such as ink jetting or LB method, and preferably obtained by a wet process with an application liquid containing the above electron-transporting material(s), semiconductor nanoparticles (described later) and fluoroalcohol as a solvent.

The thickness of the electron-transporting layer is not particularly limited, but normally about 5 nm to 5 $\mu$m, and preferably from 5 to 200 nm. The electron-transporting layer may be a single layer composed of one or more of the above materials.

Further, an electron-transporting layer doped with impurity(ies) as guest materials in addition to the semiconductor nanoparticles and having high n-type properties may be used. Examples thereof are described in Japanese Patent Application Laid-Open Publications Nos. Hei4-297076, Hei10-270172, 2000-196140 and 2001-102175, and J. Appl. Phys., 95, 5773 (2004), for example.

The electron-transporting layer of the present invention preferably contains an alkali metal salt(s) of an organic compound(s). The organic compound is not particularly limited. Examples include alkali metal salts of formic acid, acetic acid, propionic acid, butyric acid, valeric acid, capronic acid, enanthic acid, caprylic acid, oxalic acid, malonic acid, succinic acid, benzoic acid, phthalic acid, isophthalic acid, telephthalic acid, salicylic acid, pyruvic acid, lactic acid, malic acid, adipic acid, mesylic acid, tosylic acid, benzensulfonic acid; preferably an alkali metal salt of formic acid, acetic acid, propionic acid, butyric acid, valeric acid, capronic acid, enanthic acid, caprylic acid, oxalic acid, malonic acid, succinic acid and benzoic acid; a more preferable example is an alkali metal salt of an aliphatic carboxylic acid, such as formic acid, acetic acid, propionic acid or butyric acid; the number of carbons of the aliphatic carboxylic acid is preferably 4 or less; and most preferable example is an alkali metal salt of acetic acid.

An alkali metal in the alkali metal salt of the organic compound is not particularly limited and is exemplified by Na, K and Cs. K and Cr are preferable, and Cs is more preferable.

The alkali metal salt of an organic compound is exemplified by salts of the above-described organic compounds and the above-described alkali metals, and preferably lithium formate, potassium formate, sodium formate, cesium formate, lithium acetate, potassium acetate, sodium acetate, cesium acetate, lithium propionate, sodium propionate, potassium propionate, cesium propionate, lithium oxalate, sodium oxalate, potassium oxalate, cesium oxalate, lithium malonates, sodium malonate, potassium malonate, cesium malonate, lithium succinate, sodium succinate, potassium succinate, cesium succinate, lithium benzoate, sodium benzoate, potassium benzoate and cesium benzoate, more preferably lithium acetate, potassium acetate, sodium acetate and cesium acetate, and most preferably cesium acetate.

The content of the above doping material (s) is preferably 1.5 to 35% by mass, more preferably 3 to 25% by mass, and most preferably 5 to 15% by mass with respect to the electron-transporting layer to which the doping material is to be added.

(4) Mixed Layer 5, Light-Emitting Layer 6

The mixed layer 5 and the light-emitting layer 6 of the present invention will now be described in detail.

The mixed layer of the organic EL element is a mixed region containing both of a material(s) which constitute the hole-transporting layer and a material(s) which constitute the light-emitting layer.

The light-emitting layer of the organic EL element of the present invention is a layer where electrons and holes injected from the electrodes (cathode, anode), the electron-transporting layer and/or the hole-transporting layer are recombined with each other and light is then emitted. Light-emitting portions may be in the light-emitting layer or at the interface(s) between the light-emitting layer and its adjacent layer(s).

The "thickness of the mixed layer" means the thickness of a layer containing both of a material(s) which constitute the hole-transporting layer and a material(s) which constitute the light-emitting layer (as for a method for measuring this thickness, see the description later for details).

The "thickness of the light-emitting layer" means, ideally, the thickness of a light-emitting layer in the case where the light-emitting layer is applied and formed on a substrate which is not mixed with the light-emitting layer (for example, a glass substrate).

Actually, a light-emitting layer is formed on a hole-transporting layer, and a mixed layer is formed between the light-emitting layer and the hole-transporting layer. Defining that an ideal thickness of a light-emitting layer in the case

where no mixing occurs between the light-emitting layer and its underlayer as "TH1" and defining an actual thickness of a light-emitting layer in the case where mixing occurs between the light-emitting layer and its underlayer as "TH2", the actual thickness of the light-emitting layer "TH2" satisfy the relationship expressed by the following inequality (A):

(the actual thickness of the light-emitting layer TH2) < (the ideal thickness of the light-emitting layer TH1) < ((the thickness of the mixed layer) + (the actual thickness of the light-emitting layer TH2)) ... (A)

Thus, the "thickness of the light-emitting layer" according to a preferred embodiment of the present invention has an intermediate value of the inequality (A) (i.e., equal to ((the thickness of the mixed layer $\times$ 1/2) + (the actual thickness of the light-emitting layer TH2))), namely, the thickness obtained by adding a half of the thickness of the mixed layer to the actual thickness of the light-emitting layer.

The thickness of the light-emitting layer can be adjusted by changing a concentration of the application liquid, or can be adjusted by changing a rotating frequency in the case of forming the layer by spin coating.

The present inventors have eagerly studied for a method for changing the thickness of the mixed layer lowering the voltage and revealed that the thickness of the mixed layer can be changed by adjusting the temperature of an application liquid for forming a light-emitting layer and the temperature of a substrate in applying the light-emitting layer.

The temperature of the application liquid for forming a light-emitting layer and the temperature of a substrate may be different, but preferably these temperatures are equal to each other.

When the application is performed keeping the temperatures of the application liquid for forming the light-emitting layer and the substrate at room temperature at room temperature (25°C), which is a conventional application method, the thickness of the mixed layer is 4 nm. In contrast, in the present embodiment, the temperatures of the application liquid for forming the light-emitting layer and the substrate are increased to 40 to 60°C, which can adjust the thickness of the mixed layer to 5 to 15 nm.

The thickness of the mixed layer according to the present invention is 5 to 15 nm, preferably 7 to 15 nm.

The thickness of the mixed layer can be measured by X-ray photoelectron spectroscopy (XPS). The following is a specific example thereof.

On a glass substrate, a hole-transporting layer is formed, and then a sufficiently thick light-emitting layer is formed thereon, and the resulting substrate as a sample is put in an XPS analyzing device.

Measurement by XPS and sputtering in the thickness direction are repeatedly performed, and the element(s) contained in that organic functional layer of the sample can be quantified in the thickness direction. A profile in the thickness direction can be thus obtained.

In sputtering, argon cluster ions each consisting of several thousands of atoms are used. By using such argon cluster ions, damages and knock-on effects in the thickness direction can be reduced, and thus a resolution of a distribution of an element(s) in the thickness direction can be greatly improved in the measurement, compared to the case of sputtering using conventional ion sources.

In this XPS measurement, a resolution in the thickness direction is 4 nm.

The thickness of the mixed layer is determined by quantifying the central metal of a phosphorescent dopant. A phosphorescent dopant is an organic metal complex containing a characteristic metal such as Ir or Pt in its center. A material(s) contained in a hole-transporting layer do not contain such a material. Thus, the thickness of the mixed layer can be measured by quantifying this central metal.

When the measurement is performed by sputtering from a light-emitting layer to a hole-transporting layer, a position at which the amount of ions of the central metal begins to decrease is determined as the interface of the light-emitting layer and the mixed layer, and a position at which the amount of ions of the central metal stops decreasing and reaches 0 is defined as the interface of the mixed layer and the hole-transporting layer. A distance (thickness) between these two interfaces is defined as the "thickness of the mixed layer".

This method enables detailed examinations of a relationship of the thickness of the mixed layer to driving voltage and a lifetime of light emission, which realizes the present invention.

According to a preferred embodiment of the present invention, the voltage can be lowered, stability in a long-term driving can be improved, and a change in a color of emitted light after a storage in high temperature can be prevented (see an Example described later).

In a preferred embodiment of the present invention, the light-emitting layer contains one or more dopants.

In the case where a plurality of dopants are contained in the light-emitting layer, a peak of intensity of light

emitted from the dopant(s) that emit light of the shortest wavelength out of these dopants is at 500 nm or less.

A concentration of the dopant(s) (when a plurality of dopants are contained, the total concentration of the dopants) is 3 to 25% by mass with respect to the whole light-emitting layer. Preferably, the upper limit of the concentration is 21% by mass or less, more preferably 15% by mass or less, and further more preferably 10% by mass or less.

In a preferred embodiment of the present invention, a dopant(s) having a high excited triplet energy (T1) are used. If the concentration of the dopant(s) is higher than 25% by mass, excitons flow down between molecules of the dopant (s) into the mixed layer. Thus, the concentration of the dopant(s) within the above range is preferable because the desired effects on power efficiency by virtue of low voltage can be obtained.

In a preferred embodiment of the present invention, a dopant(s) having a high excited triplet energy (T1) are used. If the concentration of the dopant (s) is 25% by mass or less, excitons can be prevented from flowing down between molecules of the dopant (s) into the mixed layer. Thus, the concentration of the dopant (s) within the above range is preferable because desired effects on power efficiency by virtue of low voltage can be obtained.

In the present invention, the thickness of the light-emitting layer is 50 to 100 nm, more preferably 60 to 100 nm, and further more preferably 80 to 100 nm.

When the light-emitting layer is thick, sites where excitons are generated in the light-emitting layer can be sufficiently distant from the hole-transporting layer, and thus excitons can be prevented from diffusing into the mixed layer. Thus, the thickness of the light-emitting layer within the above range is preferably because the desired effects on power efficiency by virtue of low voltage can be obtained.

In the present invention, the thickness of the mixed layer $t_{mix}$ and the thickness of the light-emitting layer $t_{EML}$ preferably satisfy a relation expressed by $5t_{mix} + 25 \leq t_{EML} \leq 5t_{mix} + 45$.

Excitons are easier to flow out of the light-emitting layer as the thickness of the mixed layer increases, and thus the light-emitting layer is preferably thick. When the mixed layer is thin, excitons are difficult to flow out of the light-emitting layer, and thus the light-emitting layer may be thin.

In a preferred embodiment of the present invention, the light-emitting layer may contain two or more host compounds, preferably three or more host compounds, and further more preferably five to ten host compounds.

Using a plurality of host compounds can change transferability of charge and thus sites where excitons are generated can be sufficiently distant from the mixed layer, which can prevent excitons from flowing into the mixed layer.

(4.1) Dopant (Light-Emitting Material)

In a preferred embodiment of the present invention, it is preferable that a concentration of a dopant(s) that emit light of the shortest wavelength is smaller at the position more distant from the mixed layer.

As a light-emitting material (light-emitting dopant), a fluorescent compound and a phosphorescent material (also referred to as a phosphorescent compound or a phosphorescence-emitting compound) may be used, and a phosphorescent material is preferable.

In the present invention, a phosphorescent material is a compound showing light emission from an excited triplet state. Specifically, the phosphorescent material is a compound which emits phosphorescence at room temperature (25°C) and is defined as having a phosphorescence quantum yield at 25°C of 0.01 or more, and preferably 0.1 or more.

A phosphorescence quantum yield may be measured according to the method described in page 398 of the fourth series of Experimental Chemistry 7, Spectroscopy II, 1992 from MARUZEN Co., Ltd. Various solvents may be used in measuring a phosphorescence quantum yield in a solution. The phosphorescent material of the present invention may be any compound as long as a phosphorescence quantum yield of the phosphorescent dopant satisfies the above requirement (0.01 or more) .

There are two principles of light emission by a phosphorescent material.

One is an energy transfer-type, wherein the recombination of carriers occurs on a host compound onto which the carriers are transferred to produce an excited state of the host compound, and then via transfer of this energy to a phosphorescent material, light emission from the phosphorescent material occurs.

The other is a carrier trap-type, wherein a phosphorescent material serves as a carrier trap to cause recombination of carriers on the phosphorescent material, and thereby light emission from the phosphorescent material occurs.

In each type, the energy in the excited state of the phosphorescent material is required to be lower than that in the excited state of the host material.

The phosphorescent material may be a compound selected from known compounds that have been used in a light-emitting layer of an organic EL element as needed, and is preferably a complex compound containing a metal of Groups 8 to 10 of the periodic table, more preferably an iridium compound, an osmium compound, a platinum compound (platinum complex compound) or a rare earth complex, and most preferably an iridium compound.

The phosphorescent dopant of the present invention which dopant is represented by the general formula (1) will now be described in detail.

[Chemical Formula 7]

General formula (1)

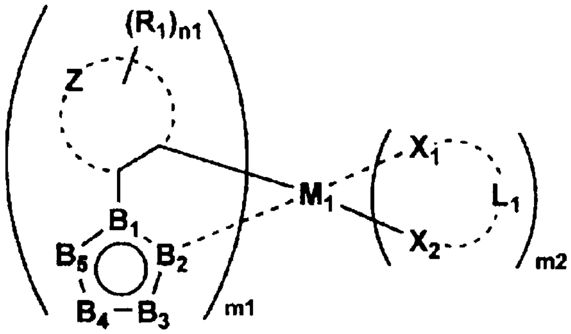

In the general formula (1), $R_1$ represents a substituent; Z represents a group of non-metal atoms necessary for forming a five to seven-membered ring; n1 represents an integer from 0 to 5; $B_1$ to $B_5$ each represent a carbon atom, a nitrogen atom, an oxygen atom or a sulfur atom and at least one of $B_1$ to $B_5$ represents a nitrogen atom; $M_1$ represents a transition metal element of Groups 8 to 10 of the periodic table; $X_1$ and $X_2$ each represent a carbon atom, a nitrogen atom or an oxygen atom; $L_1$ represents a group of atoms forming a bidentate ligand together with $X_1$ and $X_2$; m1 represents an integer 1, 2 or 3; m2 represents an integer 0, 1 or 2; and m1 + m2 is equal to 2 or 3.

The phosphorescent compound of the present invention represented by the general formula (1) has a HOMO of -5.15 to -3.50 eV and a LUMO of -1.25 to +1.00 EV, and preferably has a HOMO of -4.80 to -3.50 eV and a LUMO of -0.80 to +1.00 eV.

In the phosphorescent compound represented by the general formula (1), examples of a substituent represented by $R_1$ include alkyl groups (such as methyl group, ethyl group, propyl group, isopropyl group, tert-butyl group, pentyl group, hexyl group, octyl group, dodecyl group, tridecyl group, tetradecyl group and pentadecyl group), cycloalkyl groups (such as cyclopentyl group and cyclohexyl group), alkenyl groups (such as vinyl group and allyl group), alkynyl groups (such as ethynyl group and propargyl group), aromatic hydrocarbon ring groups (also referred to as aromatic carbon ring groups or aryl groups, such as phenyl group, p-chlorophenyl group, mesityl group, tolyl group, xylyl group, naphthyl group, anthryl group, azulenyl group, acenaphthenyl group, fluorenyl group, phenanthryl group, indenyl group, pyrenyl group and biphenyl group), aromatic hetero ring groups (such as pyridyl group, pyrimidinyl group, furyl group, pyrrolyl group, imidazolyl group, benzoimidazolyl group, pyrazolyl group, pyrazinyl group, triazolyl group (exemplified by 1,2,4-triazole-1-yl group and 1,2,3-triazole-1-yl group), oxazolyl group, benzoxazolyl group, thiazolyl group, isoxazolyl group, isothiazolyl group, furazanyl group, thienyl group, quinolyl group, benzofuryl group, dibenzofuryl group, benzothienyl group, dibenzothienyl group, indolyl group, carbazolyl group, carbolinyl group, diazacarbazolyl group (a group where one of the carbon atoms of the carboline ring of the carbolinyl group is substituted with a nitrogen atom), quinoxalinyl group, pyridazinyl group, triazinyl group, quinazolinyl group and phthalazinyl group), hetero ring groups (such as pyrrolidyl group, imidazolidyl group, morpholyl group and oxazolidyl group), alkoxy groups (such as methoxy group, ethoxy group, propyloxy group, pentyloxy group, hexyloxy group, octyloxy group and dodecyloxy group), cycloalkoxy groups (such as cyclopentyloxy group and cyclohexyloxy group), aryloxy groups (such as phenoxy group and naphthyloxy group), alkylthio groups (such as methylthio group, ethylthio group, propylthio group, pentylthio group, hexylthio group, octylthio group and dodedcylthio group), cycloalkylthio groups (such as cyclopentylthio group and cyclohexylthio group), arylthio groups (such as phenylthio group and naphthylthio group), alkoxycarbonyl groups (such as methyloxycarbonyl group, ethyloxycarbonyl group, butyloxycarbonyl group, octyloxycarbonyl group and dodecyloxycarbonyl group), aryloxycarbonyl groups (such as phenyloxycarbonyl group and naphthyloxycarbonyl group), sulfamoyl groups (such as aminosulfonyl group, methylaminosulfonyl group, dimethylaminosulfonyl group, butylaminosulfonyl group, hexylaminosulfonyl group, cyclohexylaminosulfonyl group, octylaminosulfonyl group, dodecylaminosulfonyl group, phenylaminosulfonyl group, naphthylaminosulfonyl group and 2-pyridylaminosulfonyl group), acyl groups (such as acetyl group, ethylcarbonyl group, propylcarbonyl group, pentylcarbonyl group, cyclohexylcarbonyl group, octylcarbonyl group, 2-ethylhexylcarbonyl group, dodecylcarbonyl group, phenylcarbonyl group, naphthylcarbonyl group and pyridylcarbonyl group), acyloxy groups (such as acetyloxy group, ethylcarbonyloxy group, butylcarbonyloxy group, octylcarbonyloxy group, dodecylcarbonyloxy group and phenylcarbonyloxy group), amide groups (such as methylcarbonylamino group, ethylcarbonylamino group, dimethylcarbonylamino group, propylcarbonylamino group, pentylcarbonylamino group, cyclohexylcarbonylamino group, 2-ethyhexylcarbonylamino group, octylcarbonylamino group, dodecylcarnobylamino group, phenylcarbonylamino group and naphthylcarbonylamino group), carbamoyl groups (such as aminocarbonyl group, methylaminocarbonyl group,

dimethylaminocarbonyl group, propylaminocarbonyl group, pentylaminocarbonyl group, cyclohexylcarbonylamino group, octylaminocarbonyl group, 2-ethylhexylaminocarbonyl group, dodecylaminocarbonyl group, phenylaminocarbonyl group, naphthylaminocarbonyl group and 2-pyridylaminocarbonyl group), ureido groups (such as methylureido group, ethylureido group, pentylureido group, cyclohexylureido group, octylureido group, dodecylureido group, phenylureido group, naphthylureido group and 2-pyridylaminoureido group), sulfinyl groups (such as methylsulfinyl group, ethylsulfinyl group, butylsulfinyl group, cyclohexylsulfinyl group, 2-ethylhexylsulfinyl group, dodecylsulfinyl group, phenylsulfinyl group, naphtylsulfinyl group and 2-pyridylsulfinyl group), alkylsulfonyl groups (such as methylsulfonyl group, ethylsulfonyl group, butylsulfonyl group, cyclohexylsulfonyl group, 2-ethylhexylsulfonyl group and dodecylsulfonyl group), arylsulfonyl or heteroarylsulfonyl groups (such as phenylsulfonyl group, naphthylsulfonyl group and 2-pyridylsulfonyl group), amino groups (such as amino group, ethylamino group, dimethylamino group, butylamino group, cyclopentylamino group, 2-ethylhexylamino group, dodecylamino group, anilino group, naphthylamino group and 2-pyridylamino group), cyano group, nitro group, hydroxy group, mercapto group, silyl groups (such as trimethylsilyl group, triisopropylsilyl group, triphenylsilyl group and phenyldiethylsilyl group). Among these substituents, alkyl groups and aryl groups are preferable.

Z represents a group of non-metal atoms necessary for forming a five to seven-membered ring. Example of the five to seven-membered ring formed with Z include benzene ring, naphthalene ring, pyridine ring, pyrimidine ring, pyrrole ring, thiophene ring, pyrazole ring, imidazole ring, oxazole ring and thiazole ring. Among them, benzene ring is preferable.

$B_1$ to $B_5$ each represent a carbon atom, a nitrogen atom, an oxygen atom or a sulfur atom and at least one of $B_1$ to $B_5$ represents a nitrogen atom. An aromatic hetero ring formed with $B_1$ to $B_5$ is preferably monocyclic. Examples of the aromatic hetero ring include pyrrole ring, pyrazole ring, imidazole ring, triazole ring, tetrazole ring, oxazole ring, isoxazole ring, thiazole ring, isothiazole ring, oxadiazole ring and thiadiazole ring. Among them, pyrazole ring and imidazole ring are preferable. Imidazole ring where $B_2$ and $B_5$ are nitrogen atoms is particularly preferable. The above-described rings may be substituted with the above substituent(s). Such a substituent is preferably alkyl group or aryl group, and more preferably aryl group.

$L_1$ represents a group of atoms forming a bidentate ligand together with $X_1$ and $X_2$. Examples of the bidentate ligand represented by $X_1$-$L_1$-$X_2$ include phenylpyridine, phenylpyrazole, phenylimidazole, phenyltriazole, phenyltetrazole, pyrazabole, picolinic acid and acetyl acetone. These compounds may be substituted or non-substituted.

In the formula, m1 represents an integer from 1 to 3; m2 represents an integer from 0 to 2; and m1 + m2 equals to 2 or 3. Preferably, m2 is 0. As a metal represented by $M_1$, a transition metal element of Groups 8 to 10 of the periodic table (also referred to simply as a transition metal) is used, and iridium and platinum are preferable. Iridium is more preferable.

Specific examples of the phosphorescent dopant represented by the general formula (1) (D-1 to D-133) will now be described, but the present invention is not limited thereto.

[Chemical Formula 8]

D-1
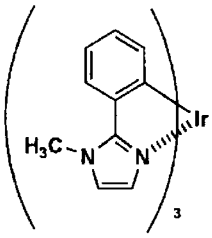

D-2
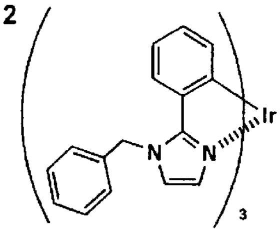

D-3
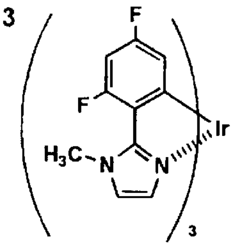

D-4
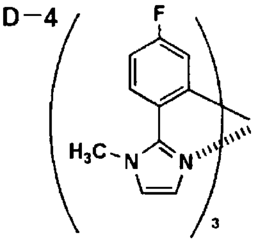

D-5
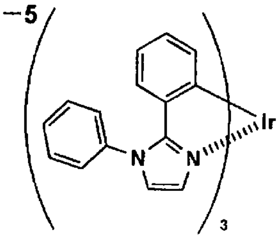

D-6
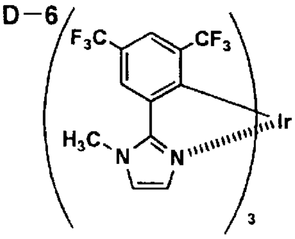

D-7
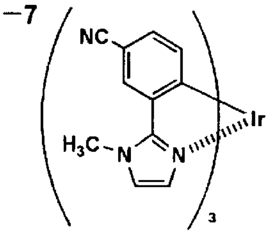

D-8
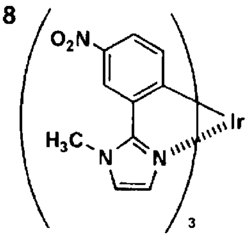

D-9
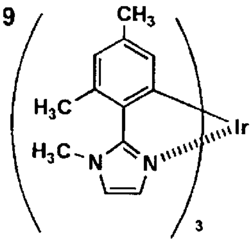

D-10
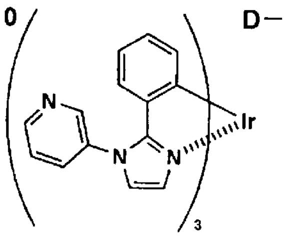

D-11
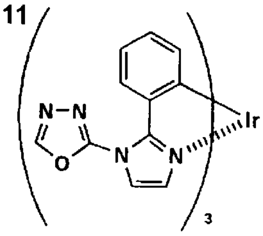

D-12
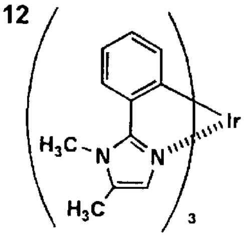

D-13
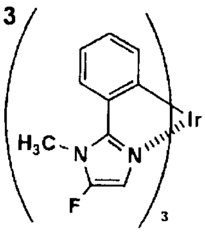

D-14
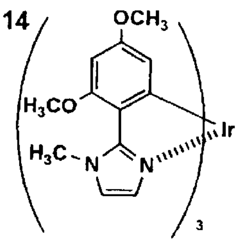

D-15
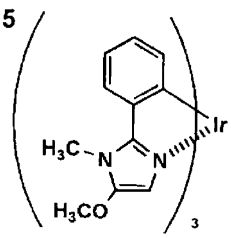

[Chemical Formula 9]

D−16
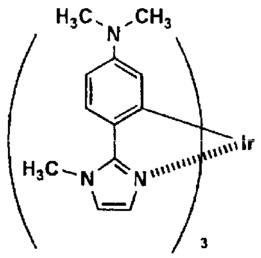

D−17
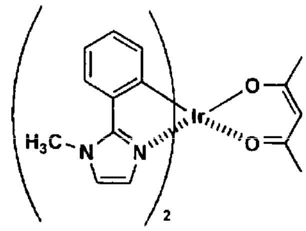

D−18
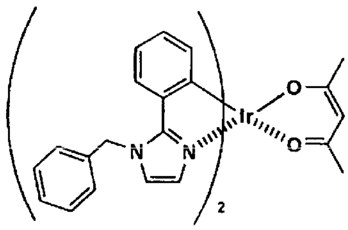

D−19
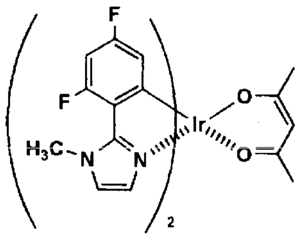

D−20
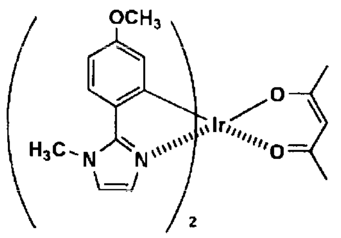

D−21
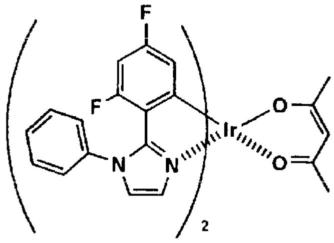

D−22
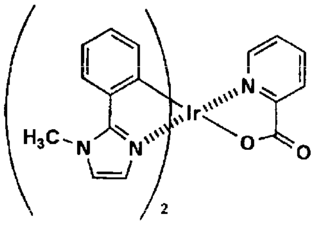

D−23
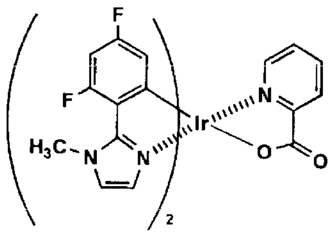

D−24
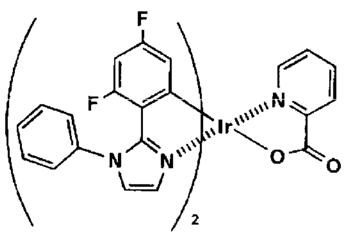

D−25
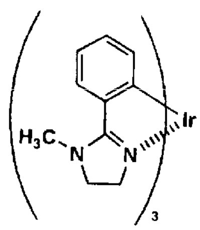

[Chemical Formula 10]

D-26

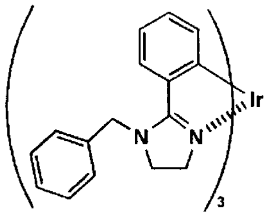

D-27

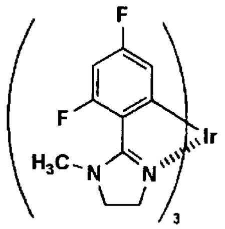

D-28

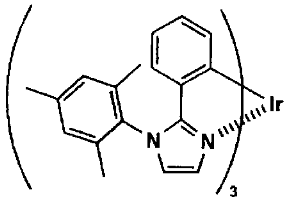

D-29

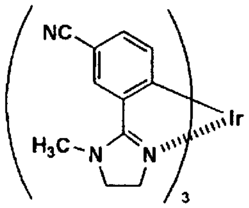

D-30

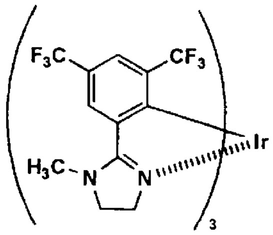

D-31

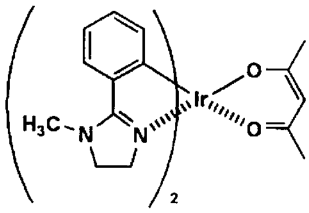

D-32

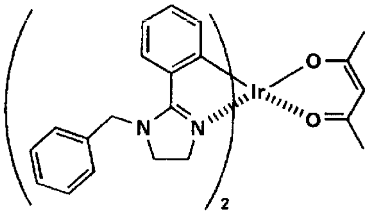

D-33

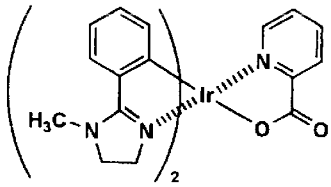

D-34

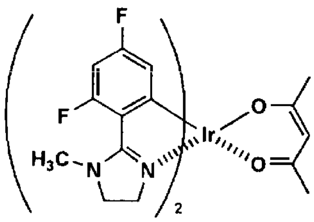

D-35

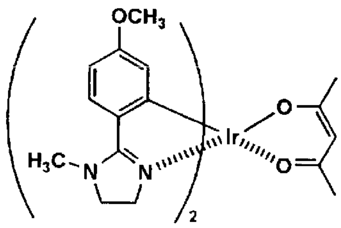

D-36

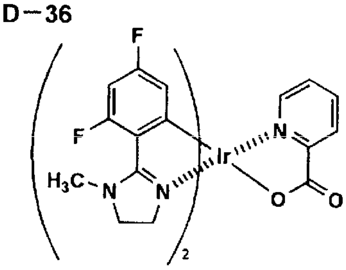

D-37

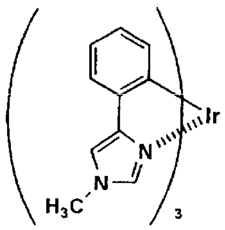

D-38

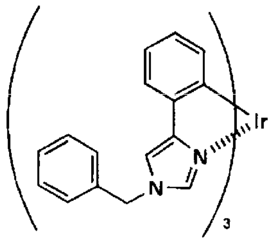

[Chemical Formula 11]

D-39

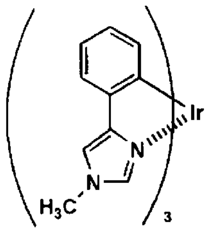

D-40

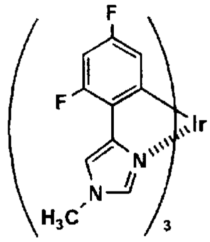

D-41

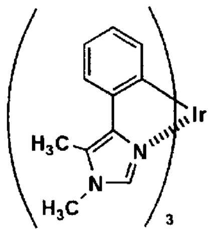

D-42

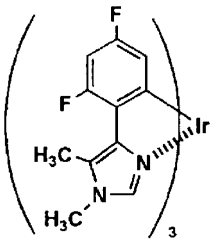

D-43

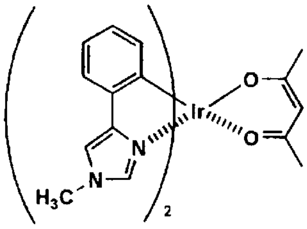

D-44

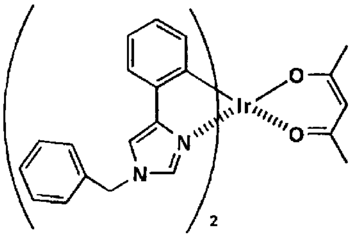

D-45

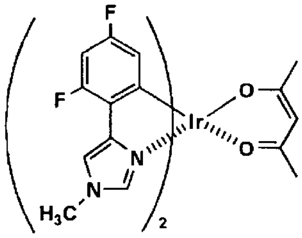

D-46

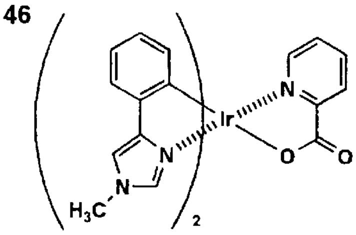

D-47

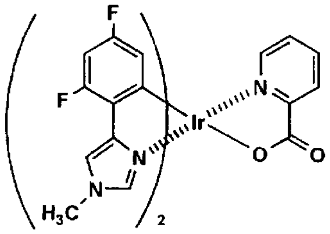

D-48

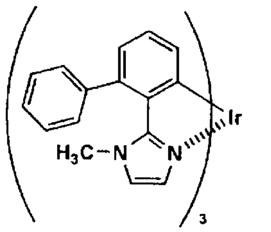

D-49

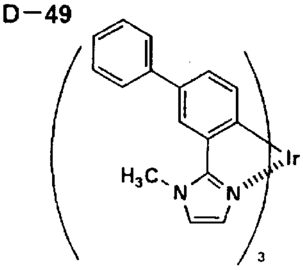

D-50

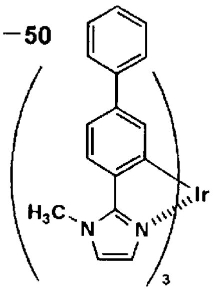

D-51

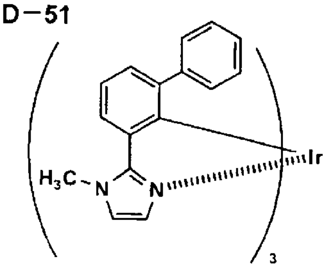

[Chemical Formula 12]

D−52

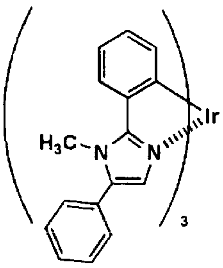

D−53

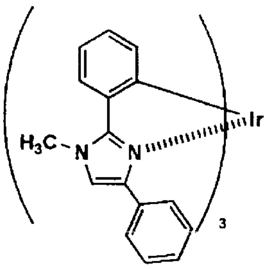

D−54

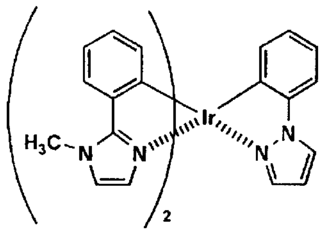

D−55

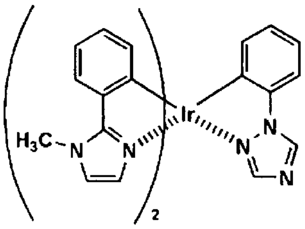

D−56

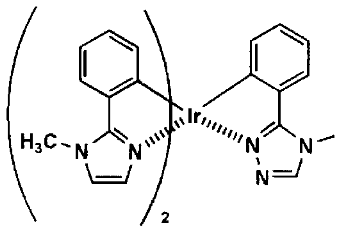

D−57

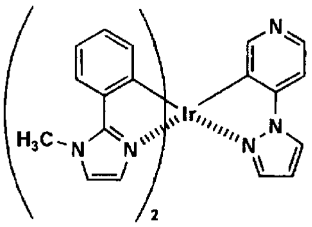

D−58

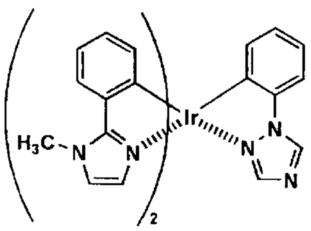

D−59

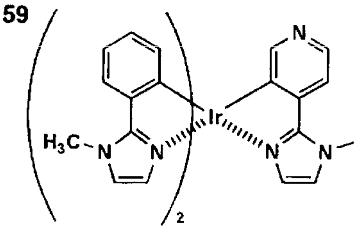

D−60

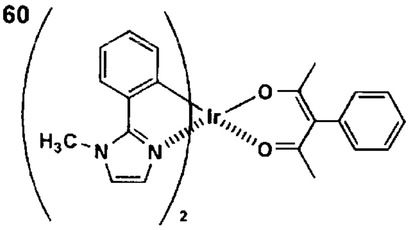

D−61

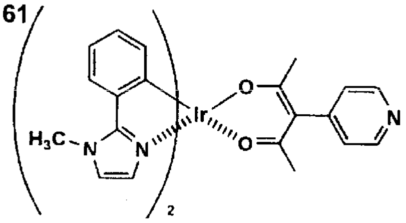

D−62

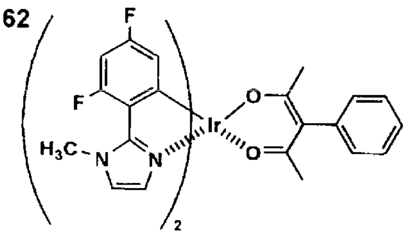

[Chemical Formula 13]

D−63

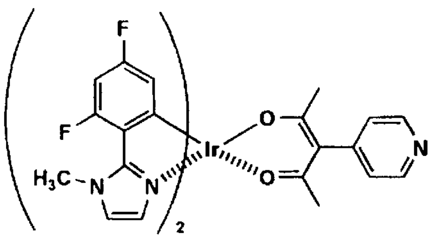

D−64

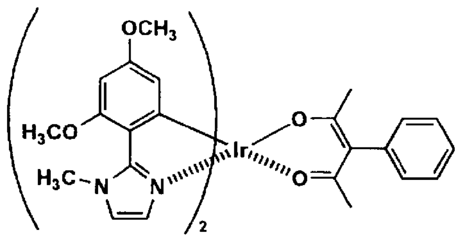

D-65

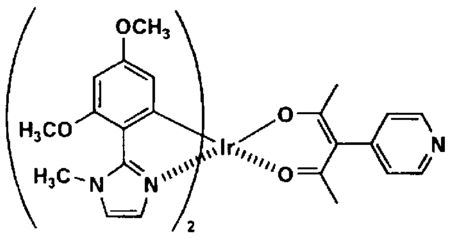

D-66

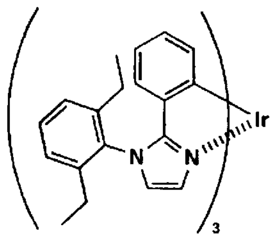

[Chemical Formula 14]

D-67

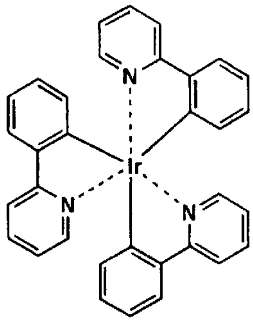

D-68

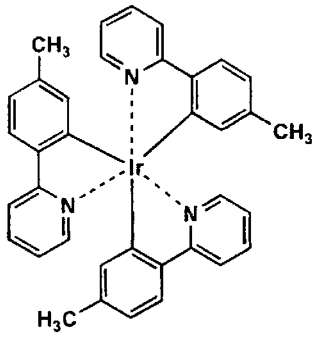

D-69

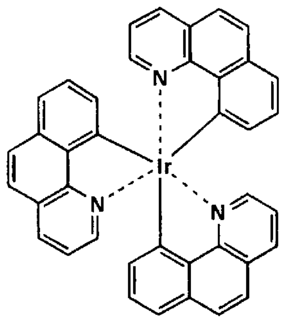

D-70

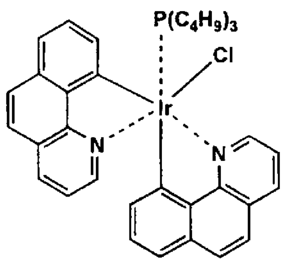

D-71

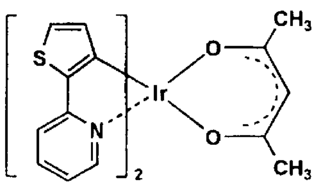

D-72

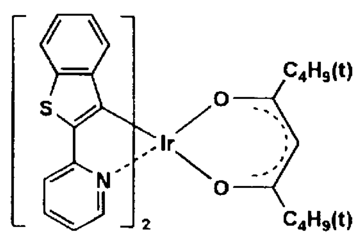

[Chemical Formula 15]

D-73

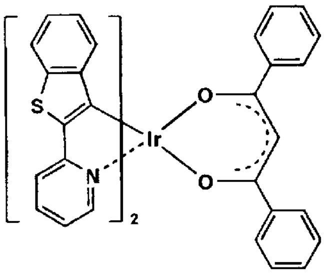

D-74

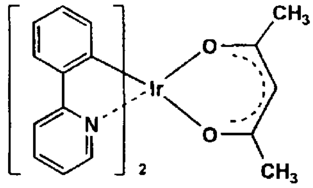

D-75

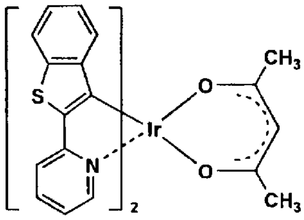

D-76

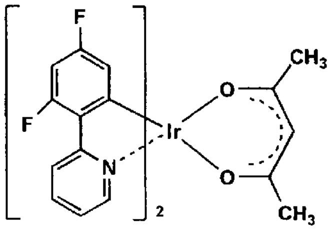

D-77

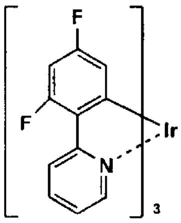

D-78

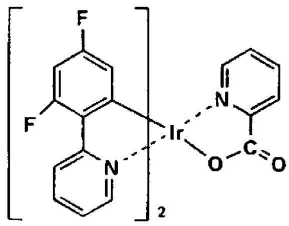

D-79

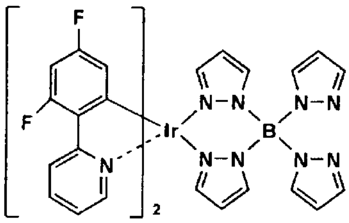

D-80

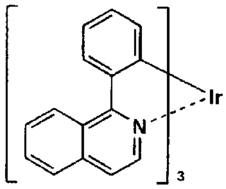

[Chemical Formula 16]

D-81

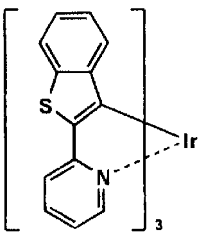

D-82

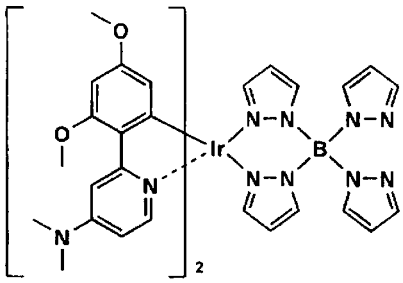

[Chemical Formula 17]

D−83

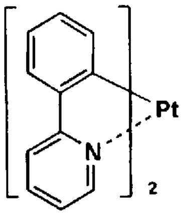

D−84

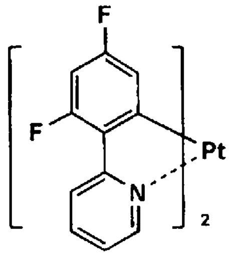

D−85

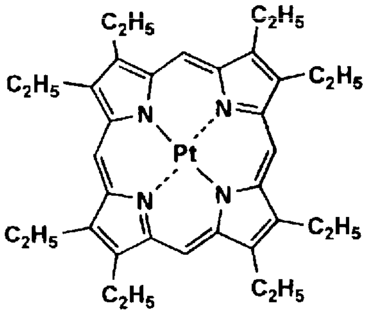

D−86

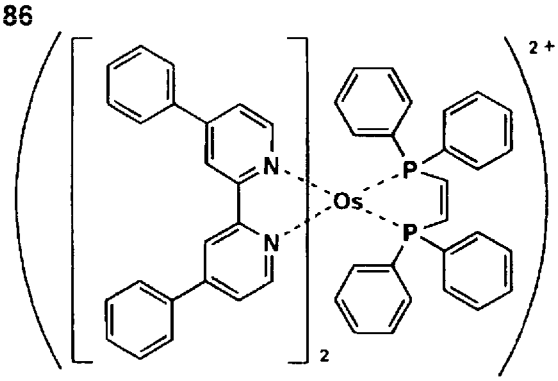

$(CF_3CF_2CF_2COO^-)_2$

[Chemical Formula 18]

D-87

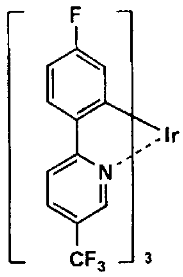

D-88

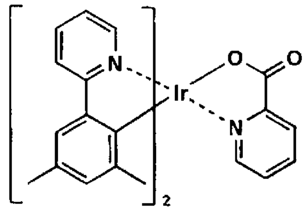

D-89

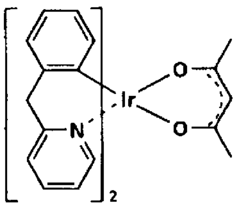

D-90

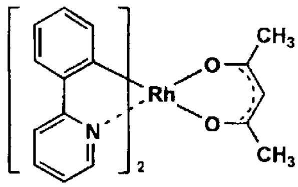

D-91

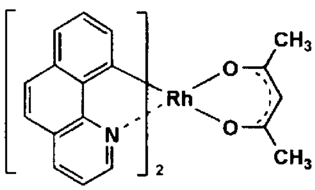

D-92

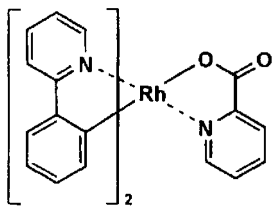

D-93

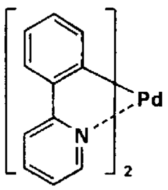

D-94

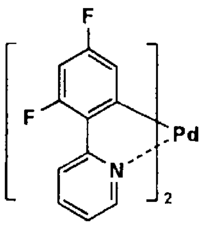

D-95

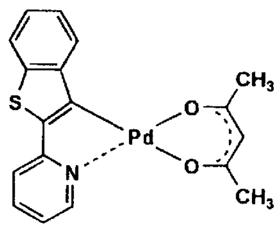

[Chemical Formula 19]

D-96

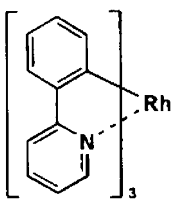

D-97

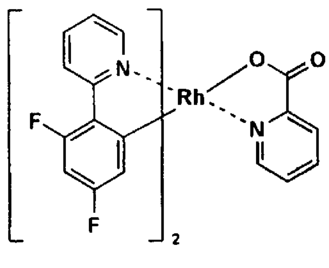

D-98

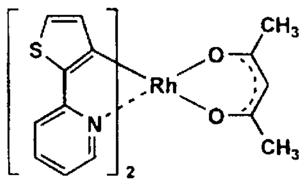

[Chemical Formula 20]

D-99

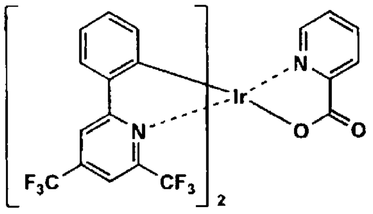

D-100

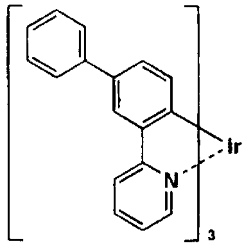

D-101

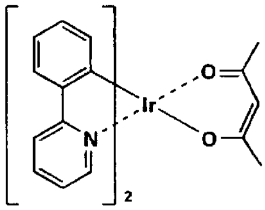

D-102

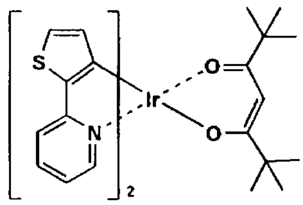

D-103

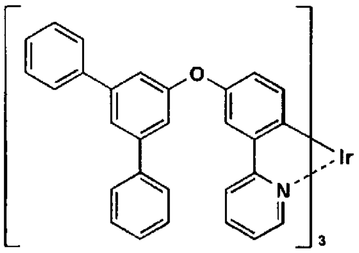

D-104

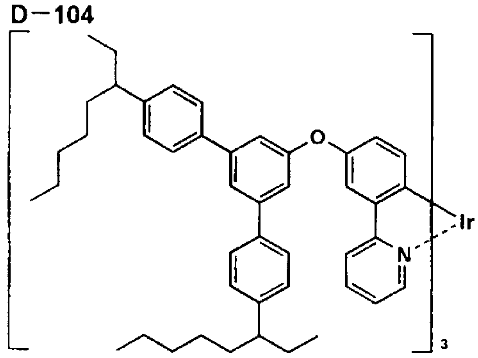

D-105

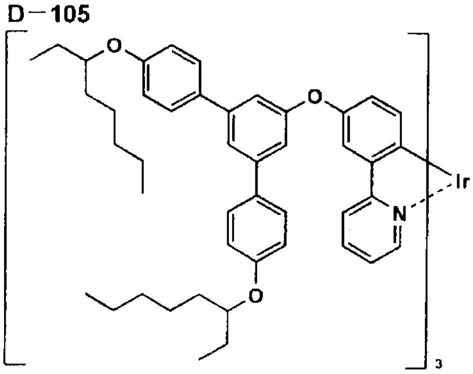

[Chemical Formula 21]

D−106

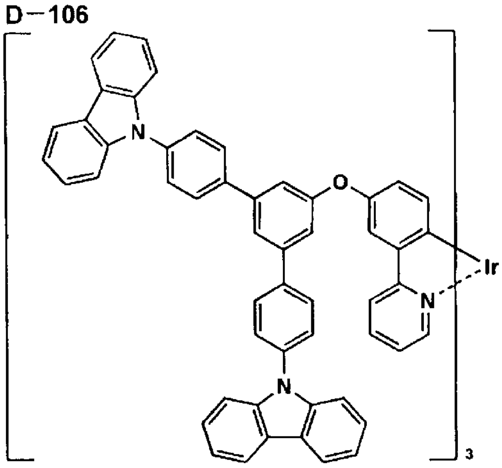

D−107

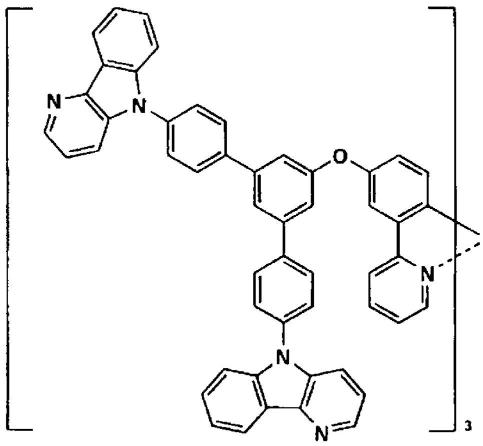

D−108

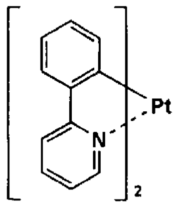

D−109

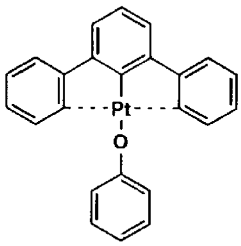

D−110

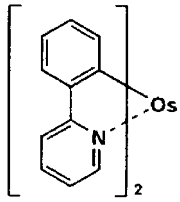

D−111

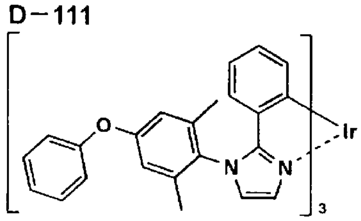

[Chemical Formula 22]

D−112

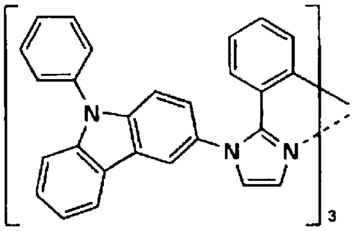

D−113

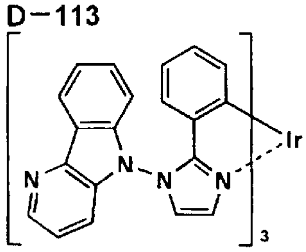

D−114

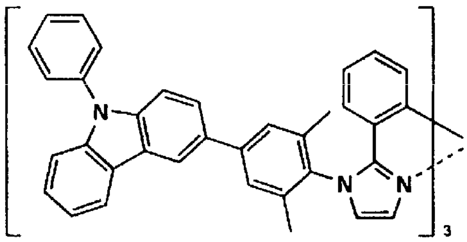

D−115

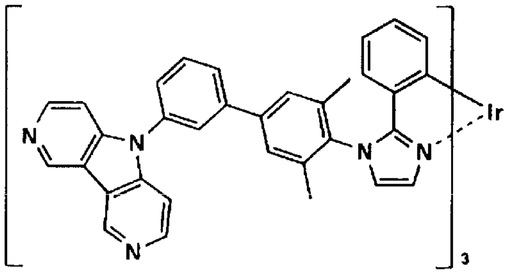

D−116

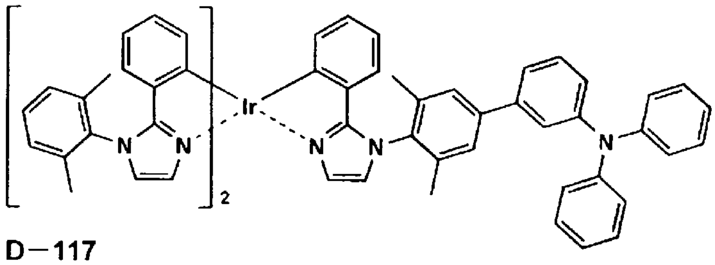

D−117

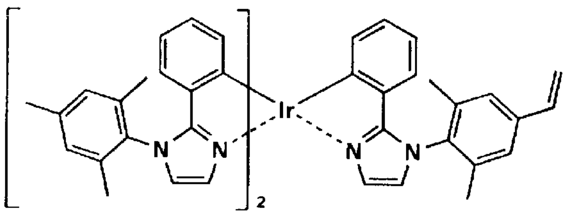

[Chemical Formula 23]

D-118

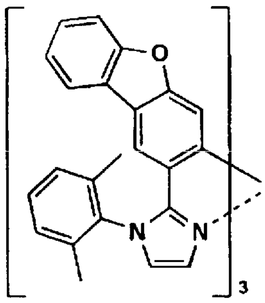

D-119

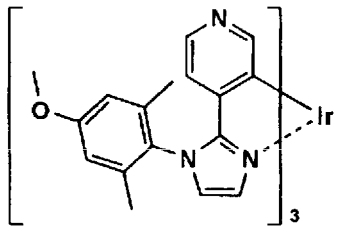

D-120

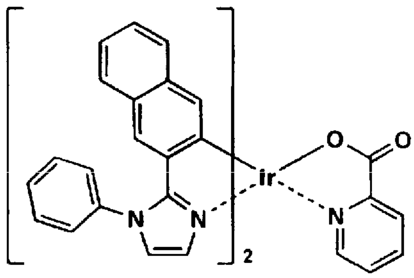

D-121

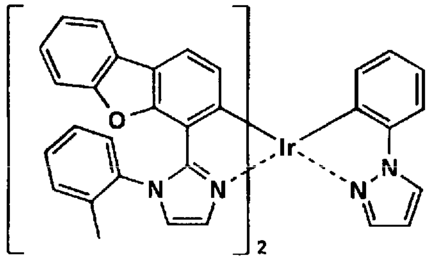

D-122

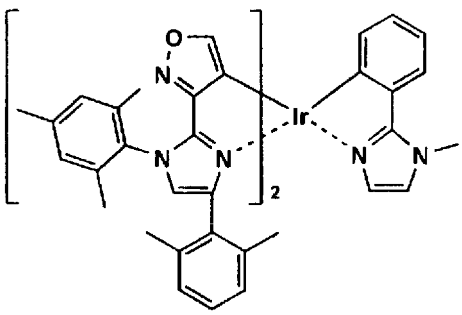

D-123

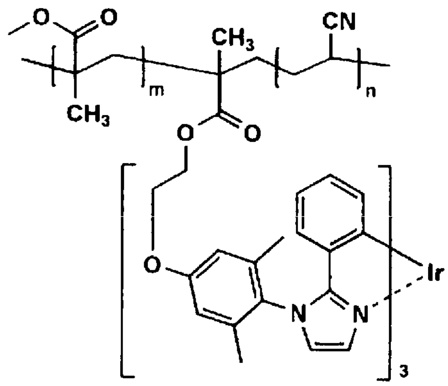

[Chemical Formula 24]

D-124

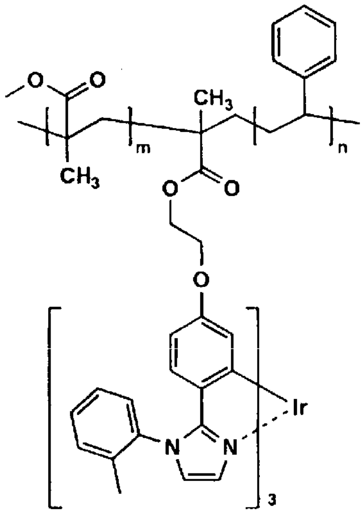

D-125

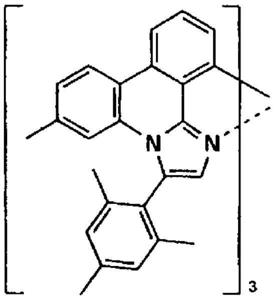

D-126

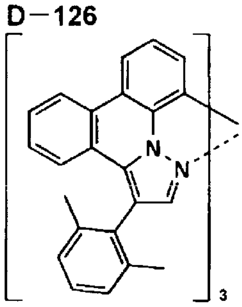

D-127

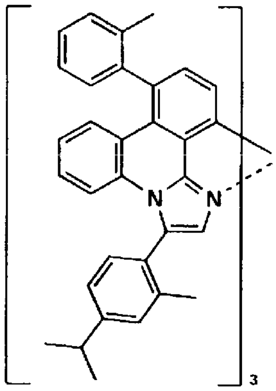

D-128

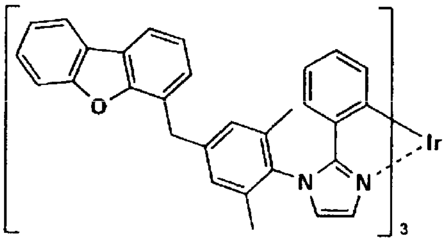

D-129

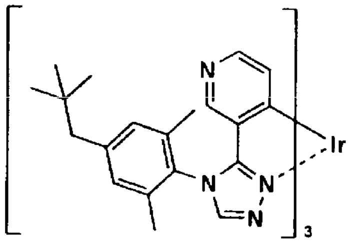

[Chemical Formula 25]

D−130

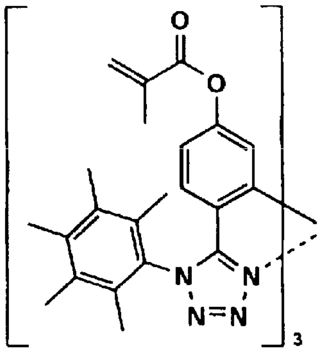

D−131

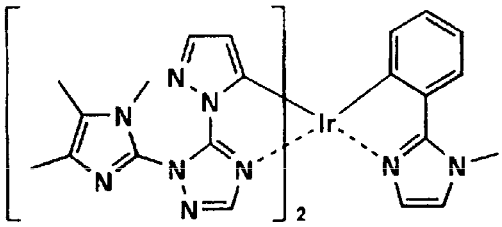

D−132

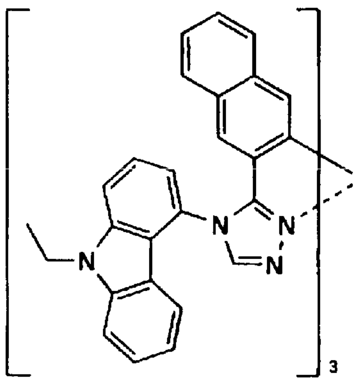

D−133

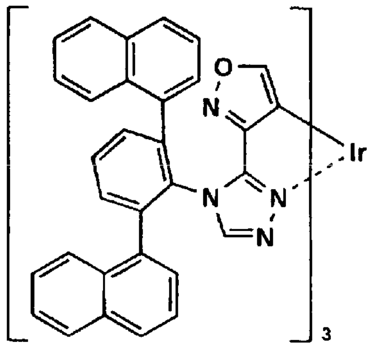

(4.2) Host Compound

Molecular weight of the host compound is preferably 1500 or less, more preferably 1200 or less, and further more preferably 800 or less.

The light-emitting layer can be obtained by forming a thin layer with the light-emitting material(s) and the host material(s) by a known film-forming method such as vacuum deposition, spin coating, casting, LB method and ink jetting.

The light-emitting layer may include a plurality of light-emitting materials. A phosphorescent material(s) and a fluorescent material(s) may be mixed together in a single light-emitting layer.

It is preferable that the light-emitting layer preferably contains a host compound(s) and a light-emitting material(s) (also referred to as a light-emitting dopant compound(s)) and that the light-emitting material(s) is made emit light.

The host compound contained in the light-emitting layer of the organic EL element of the present invention is a compound having a phosphorescence quantum yield in phosphorescence emission at room temperature (25°C) of less than 0.1, and more preferably less than 0.01. The non-light-emitting organic material may be the host compound.

When a plurality of know host compounds or a plurality of light-emitting materials described later are used, light of different colors can be mixed, and thus any desired light colors can be obtained.

Preferably, the known host compound has hole-transporting properties and electron-transporting properties, prevents light wavelength from being lengthened, and has high Tg (glass transition temperature).

Grass transition temperature (Tg) is obtained by a method according to JIS-K-7121 using a DSC (Differential Scanning Colorimetry) .

Specific examples of the known host compound include compounds described in, for example, Japanese Patent Application Laid-open Publications Nos.2001-257076, 2002-308855, 2001-313179, 2002-319491, 2001-357977, 2002-334786, 2002-8860, 2002-334787, 2002-15871, 2002-334788, 2002-43056, 2002-334789, 2002-75645, 2002-338579, 2002-105445, 2002-343568, 2002-141173, 2002-352957, 2002-203683, 2002-363227, 2002-231453, 2003-3165, 2002-234888, 2003-27048, 2002-255934, 2002-260861, 2002-280183, 2002-299060, 2002-302516, 2002-305083, 2002-305084 and 2002-308837.

The host compound used in the present invention is preferably a carbazole derivative.

Preferably, a compound represented by the general formula (2) is used as the host compound. More preferably, the number of the partial structures represented by the general formula (2) and contained in the molecule of the host compound is 3 or more.

[Chemical Formula 26]

General formula (2)

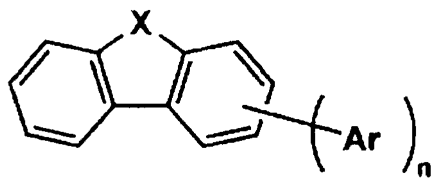

In the general formula (2), X represents NR', O, S, CR'R'' or SiR'R'' ; R' and R'' each represent a hydrogen atom or a substituent; Ar represents an aromatic ring; and n represents an integer from 0 to 8.

In X of the general formula (2), examples of substituents each represented by R' or R'' include alkyl groups (such as methyl group, ethyl group, propyl group, isopropyl group, *t*-butyl group, pentyl group, hexyl group, octyl group, dodecyl group, tridecyl group, tetradecyl group and pentadecyl group), cycloalkyl groups (such as cyclopentyl group and cyclohexyl group), alkenyl groups (such as vinyl group and allyl group), alkynyl groups (such as ethynyl group and propargyl group), aromatic hydrocarbon ring groups (also referred to as aromatic carbon ring groups or aryl groups, such as phenyl group, p-chlorophenyl group, mesityl group, tolyl group, xylyl group, naphthyl group, anthryl group, azulenyl group, acenaphthenyl group, fluorenyl group, phenanthryl group, indenyl group, pyrenyl group and biphenyl group), aromatic hetero ring groups (such as pyridyl group, pyrimidinyl group, furyl group, pyrrolyl group, imidazolyl group, benzoimidazolyl group, pyrazolyl group, pyrazinyl group, triazolyl group (exemplified by 1, 2, 4-triazole-1-yl group and 1, 2, 3-triazole-1-yl group), oxazolyl group, benzoxazolyl group, thiazolyl group, isoxazolyl group, isothiazolyl group, furazanyl group, thienyl group, quinolyl group, benzofuryl group, dibenzofuryl group, benzothienyl group, dibenzothienyl group, indolyl group, carbazolyl group, carbolinyl group, diazacarbazolyl group (a group where one of the carbon atoms of the carboline ring of the carbolinyl group is substituted with a nitrogen atom), quinoxalinyl group, pyridazinyl group, triazinyl group, quinazolinyl group and phthalazinyl group), hetero ring groups (such as pyrrolidyl group, imidazolidyl group, morpholyl group and oxazolidyl group), alkoxy groups (such as methoxy group, ethoxy group, propyloxy group, pentyloxy group, hexyloxy group, octyloxy group and dodecyloxy group), cycloalkoxy groups (such as cyclopentyloxy group and cyclohexyloxy group), aryloxy groups (such as phenoxy group and naphthyloxy group), alkylthio groups (such as methylthio group, ethylthio group, propylthio group, pentylthio group, hexylthio group, octylthio group and dodedcylthio group), cycloalkylthio groups (such as cyclopentylthio group and cyclohexylthio group), arylthio groups (such as phenylthio group and naphthylthio group), alkoxycarbonyl groups (such as methyloxycarbonyl group, ethyloxycarbonyl group, butyloxycarbonyl group, octyloxycarbonyl group and dodecyloxycarbonyl group), aryloxycarbonyl groups (such as phenyloxycarbonyl group and naphthyloxycarbonyl group), sulfamoyl groups (such as aminosulfonyl group, methylaminosulfonyl group, dimethylaminosulfonyl group, butylaminosulfonyl group, hexylaminosulfonyl group, cyclohexylaminosulfonyl group, octylaminosulfonyl group, dodecylaminosulfonyl group, phenylaminosulfonyl group, naphthylaminosulfonyl group and 2-pyridylaminosulfonyl group), acyl groups (such as acetyl group, ethylcarbonyl group, propylcarbonyl group, pentylcarbonyl group, cyclohexylcarbonyl group, octylcarbonyl group, 2-ethylhexylcarbonyl group, dodecylcarbonyl group, phenylcarbonyl group, naphthylcarbonyl group and pyridylcarbonyl group), acyloxy groups (such as acetyloxy group, ethylcarbonyloxy group, butylcarbonyloxy group, octylcarbonyloxy group, dodecylcarbonyloxy group and phenylcarbonyloxy group), amide groups (such as methylcarbonylamino group, ethylcarbonylamino group, dimethylcarbonylamino group, propylcarbonylamino group, pentylcarbonylamino group, cyclohexylcarbonylamino group, 2-ethyhexylcarbonylamino group, octylcarbonylamino group, dodecylcarnobylamino group, phenylcarbonylamino group and naphthylcarbonylamino group), carbamoyl groups (such as aminocarbonyl group, methylaminocarbonyl group, dimethylaminocarbonyl group, propylaminocarbonyl group, pentylaminocarbonyl group, cyclohexylcarbonylamino group, octylaminocarbonyl group, 2-ethylhexylaminocarbonyl group, dodecylaminocarbonyl group, phenylaminocarbonyl group, naphthylaminocarbonyl group and 2-pyridylaminocarbonyl group), ureido groups (such as methylureido group, ethylureido group, pentylureido group, cyclohexylureido group, octylureido group, dodecylureido group, phenylureido group, naphthylureido group and 2-pyridylaminoureido group), sulfinyl groups (such as methylsulfinyl group, ethylsulfinyl group, butylsulfinyl group, cyclohexylsulfinyl group, 2-ethylhexylsulfinyl group, dodecylsulfinyl group, phenylsulfinyl group, naphtylsulfinyl group and 2-pyridylsulfinyl group), alkylsulfonyl groups (such as methylsulfonyl group, ethylsulfonyl group, butylsulfonyl group, cyclohexylsulfonyl group, 2-ethylhexylsulfonyl group and dodecylsulfonyl group), arylsulfonyl or heteroarylsulfonyl groups (such as phenylsulfonyl group, naphthylsulfonyl group and 2-pyridylsulfonyl group), amino groups (such as amino group, ethylamino group, dimethylamino group, butylamino group, cyclopentylamino group, 2-ethylhexylamino group, dodecylamino group, anilino group, naphthylamino group and 2-pyridylamino group), halogen atoms (such as fluorine atom, chlorine atom and bromine atom), fluorohydrocarbon groups (such as fluoromethyl group,

trifluoromethyl group, pentafluoroethyl group and pentafluorophenyl group), cyano group, nitro group, hydroxy group, mercapto group, silyl groups (such as trimethylsilyl group, triisopropylsilyl group, triphenylsilyl group and phenyldiethylsilyl group). These substituents may be substituted with the above substituent (s). These substituents may be bonded to each other to form a ring(s).

Among them, X is preferably NR' or O. Particularly preferable examples of R' are aromatic hydrocarbon ring groups (also referred to as aromatic carbon ring groups or aryl groups, such as phenyl group, p-chlorophenyl group, mesityl group, tolyl group, xylyl group, naphthyl group, anthryl group, azulenyl group, acenaphthenyl group, fluorenyl group, phenanthryl group, indenyl group, pyrenyl group and biphenyl group) and aromatic hetero ring groups (such as furyl group, thienyl group, pyridyl group, pyridazinyl group, pyrimidinyl group, pyrazinyl group, triazinyl group, imidazolyl group, pyrazolyl group, thiazolyl group, quinazolinyl group and phthalazinyl group).

These aromatic hydrocarbon groups and aromatic hetero ring groups may be substituted with a substituent (s) each represented by R' or R" in X of the general formula (2).

Examples of the aromatic ring represented by Ar in the general formula (2) include aromatic hydrocarbon rings and aromatic hetero rings. Such an aromatic ring may be monocyclic or a fused ring, and may be non-substituted or substituted with a substituent (s) each represented by R' or R" in X of the general formula (2).

In the general formula (2), examples of the aromatic hydrocarbon ring represented by Ar of the general formula (2) include benzene ring, biphenyl ring, naphthalene ring, azulene ring, anthracene ring, phenanthrene ring, pyrene ring, chrysene ring, naphthacene ring, triphenylene ring, *o*-terphenyl ring, *m*-terphenyl ring, *p*-terphenyl ring, acenaphthene ring, coronene ring, fluorene ring, fluoranthrene ring, naphthacene ring, pentacene ring, perylene ring, pentaphene ring, picene ring, pyrene ring, pyranthrene ring, anthranthrene ring. These rings may be substituted with a substituent(s) each represented by R' or R" in X of the general formula (2).

In the partial structure represented by the general formula (2), examples of the aromatic hetero ring represented by Ar include furan ring, dibenzofuran ring, thiophene ring, oxazole ring, pyrrole ring, pyridine ring, pyridazine ring, pyrimidine ring, pyrazine ring, triazine ring, benzoimidazole ring, oxadiazole ring, triazole ring, imidazole ring, pyrazole ring, thiazole ring, indole ring, indazole ring, benzoimidazole ring, benzothiazole ring, benzoxazole ring, quinoxaline ring, quinazoline ring, cinnoline ring, quinoline ring, isoquinoline ring, phthalazine ring, naphthyridine ring, carbazole ring, carboline ring and diazacarbazole ring (a ring where one carbon atom of the hydrocarbon ring constituting the carboline ring is substituted with a nitrogen atom).

These rings may be substituted with a substituent (s) each represented by R' or R" in X of the general formula (2).

Among them, preferable the aromatic ring represented by Ar of the general formula are carbazole ring, carboline ring, dibenzofuran ring and benzene ring. A substituted benzene ring is more preferable, and a benzene ring containing a carbazolyl group(s) is particularly preferable.

A preferable example of the aromatic ring represented by Ar of the general formula (2) is a fused ring derived from 3 or more rings. Examples of the fused aromatic hydrocarbon ring where 3 or more rings are fused together include naphthacene ring, anthracene ring, tetracene ring, pentacene ring, hexacene ring, phenanthrene ring, pyrene ring, benzopyrene ring, benzoazulene ring, chrysene ring, benzochrysene ring, acenaphthene ring, acenaphthylene ring, triphenylene ring, coronene ring, benzocoronene ring, hexabenzocoronene ring, fluorene ring, benzofluorene ring, fluoranthene ring, perylene ring, naphthoperylene ring, pentabenzoperylene ring, benzoperylene ring, pentaphene ring, picene ring, pyranthrene ring, coronene ring, naphthocoronene ring, ovalene ring anthranthrene ring. These rings may be substituted with the above substituent(s).

Examples of the aromatic hetero ring where 3 or more rings are fused together include acridine ring, benzoquinoline ring, carbazole ring, carboline ring, phenazine ring, phenanthridine ring, phenanthroline ring, carboline ring, cyclazine ring, quindoline ring, tepenijine ring, quinindoline ring, triphenodithiazine ring, triphenodioxazine ring, phenanthridine, ring, anthrazine ring, perimidine ring, diazacarbazole ring (a ring where one carbon atom of the hydrocarbon ring constituting the carboline ring is substituted with a nitrogen atom), phenanthroline ring, dibenzofuran ring, dibenzothiophene ring, naphthofuran ring, naphthothiophene ring, benzodifuran ring, benzothiophene ring, naphthodifuran ring, naphthodithiophene ring, anthrafuran ring, anthradifuran ring, anthrathiophene ring, anthradithiophene ring, thianthrene ring, phenoxathiin ring and thiophanthrene ring (naphthothiophene ring). These rings may be substituted with a substituent(s).

In the general formula (2), n represents an integer from 0 to 8, and preferably from 0 to 2. In the case where X is O or S, n is preferably 1 or 2.

In the present invention, the host compound containing a dibenzofuran ring(s) and a carbazole ring(s) is particularly preferable.

Specific examples of the host compound represented by the general formula (2) (a-1 to a-41) are described below, but the present invention is not limited thereto.

[Chemical Formula 27]

a-1

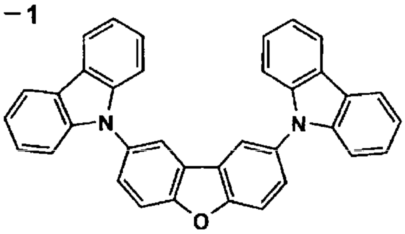

a-2

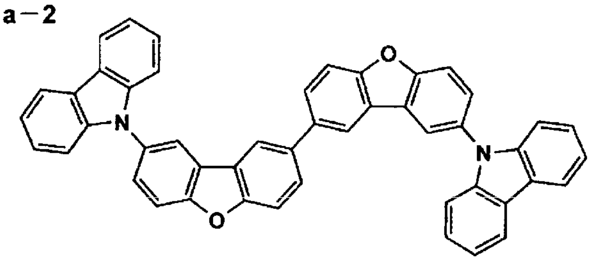

a-3

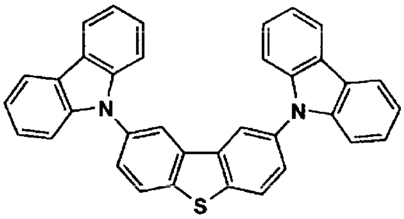

a-4

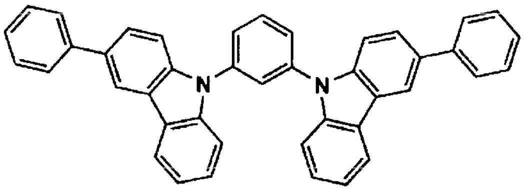

a-5

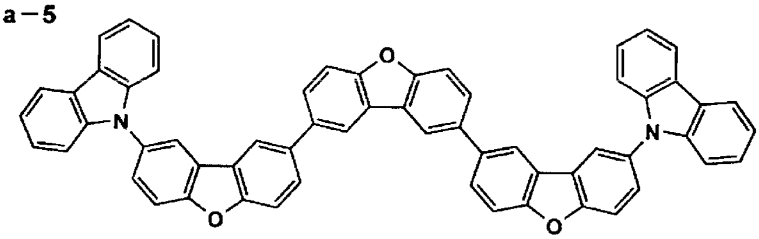

a-6

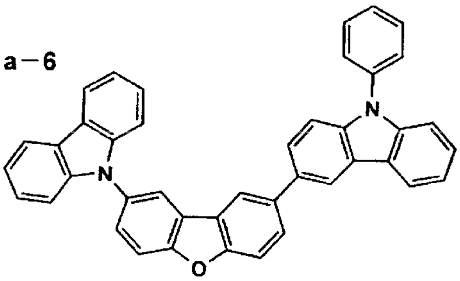

[Chemical Formula 28]

a−7

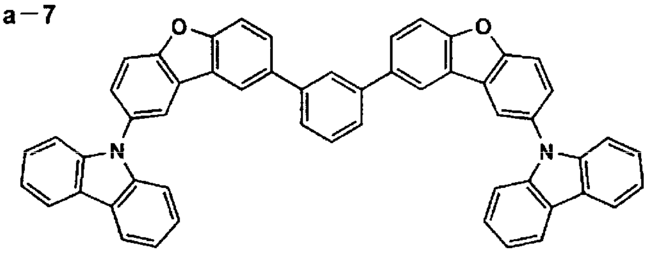

a−8

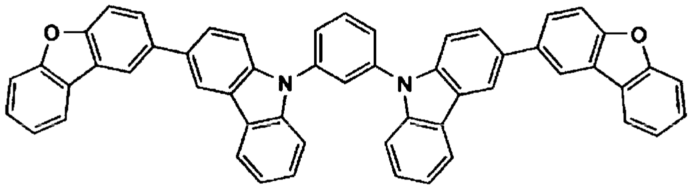

a−9

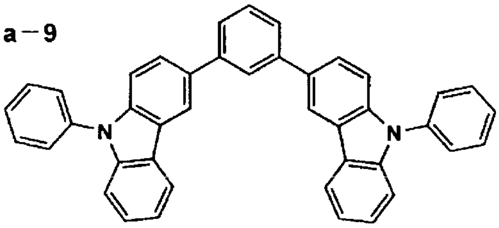

a−10

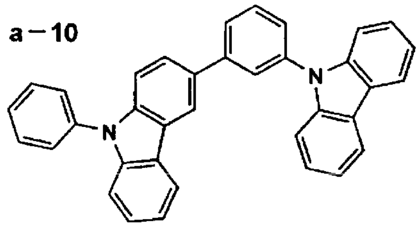

a−11

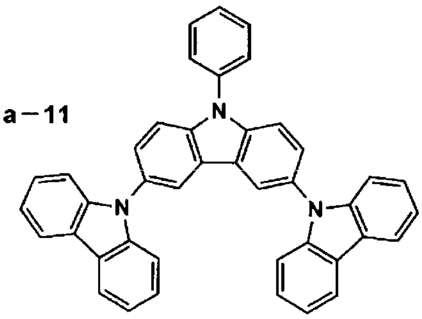

a−12

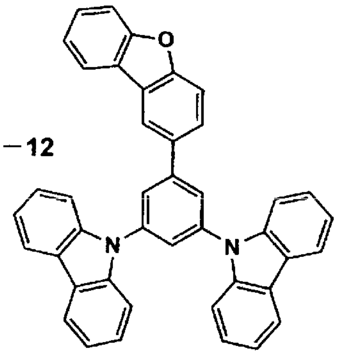

[Chemical Formula 29]

a－13

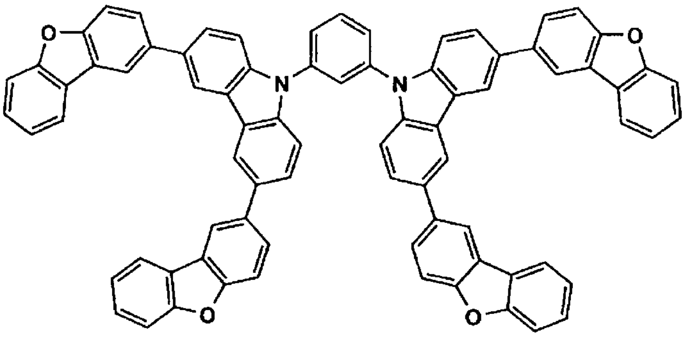

a－14

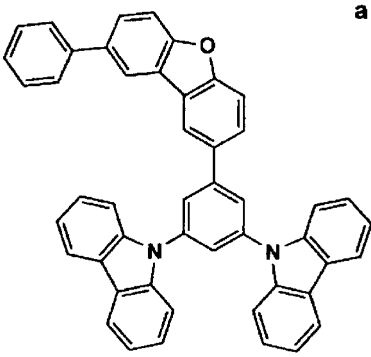

a－15

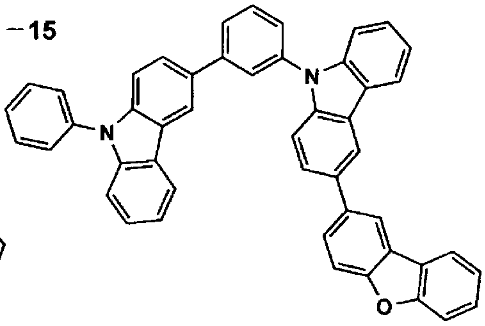

a－16

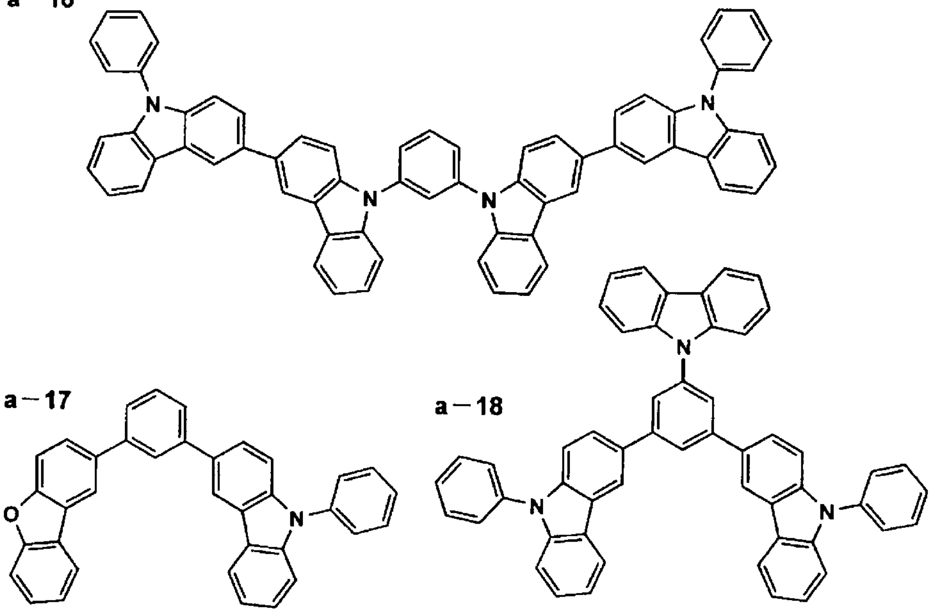

a－17

a－18

[Chemical Formula 30]

a－19

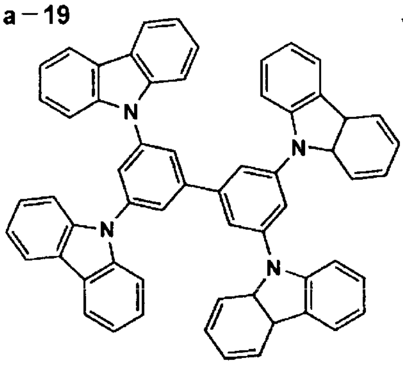

a－20

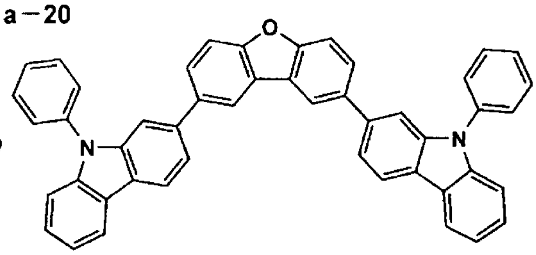

a－21

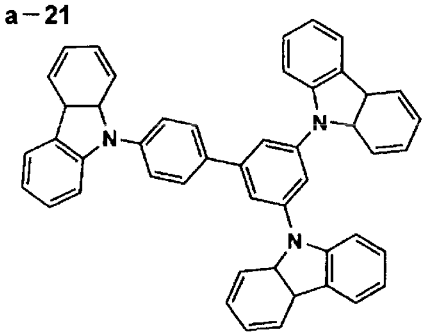

a－22

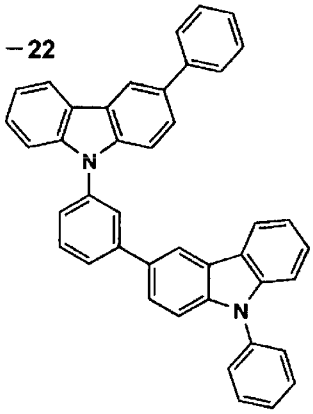

a－23

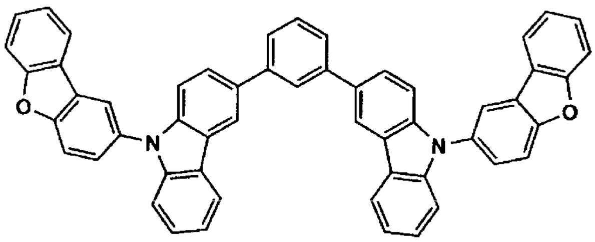

a－24

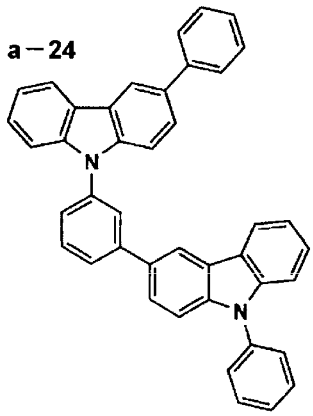

[Chemical Formula 31]

a-25

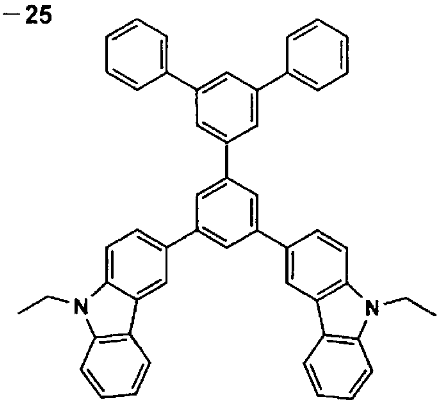

a-26

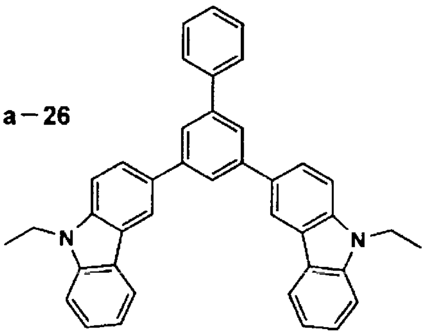

a-27

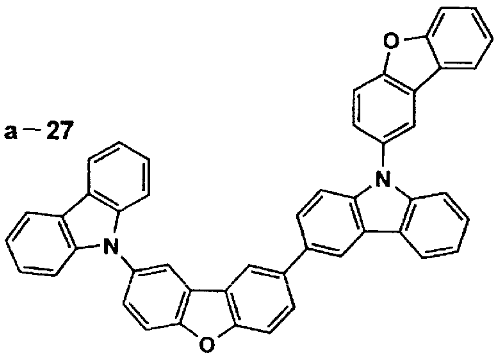

a-28

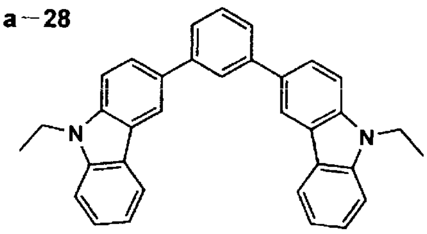

a-29

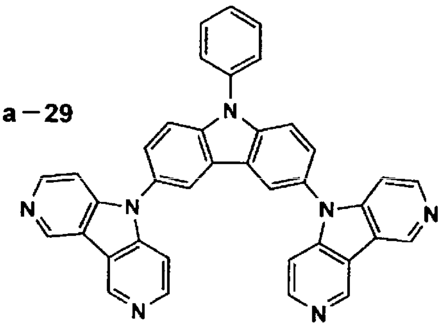

[Chemical Formula 32]

a－30

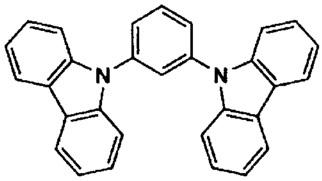

a－31

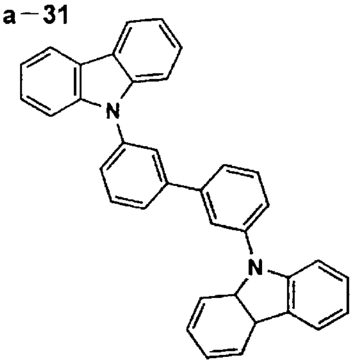

a－32

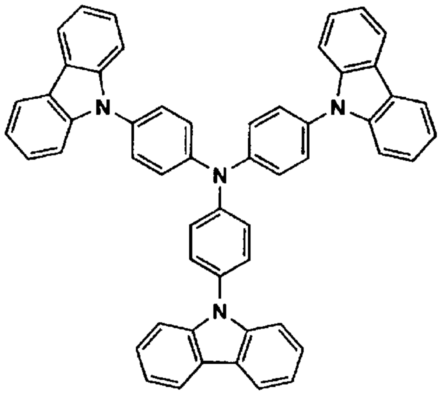

a－33

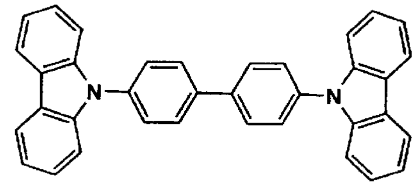

a－34

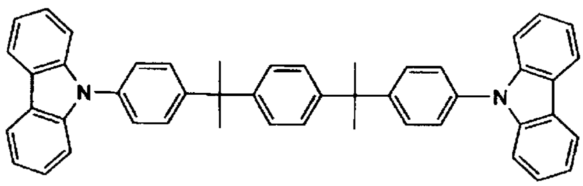

[Chemical Formula 33]

a－35

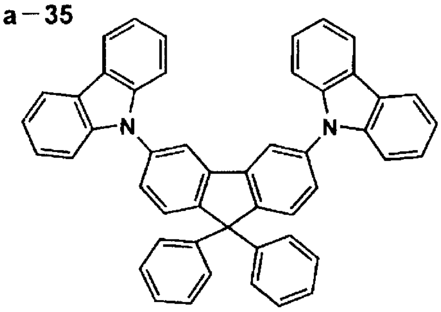

a－36

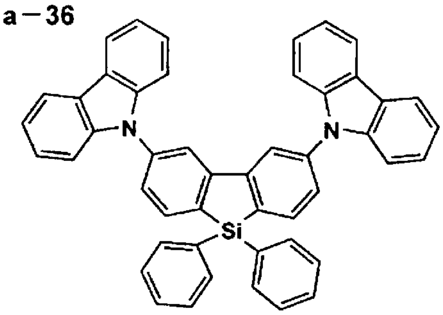

[Chemical Formula 34]

a−37

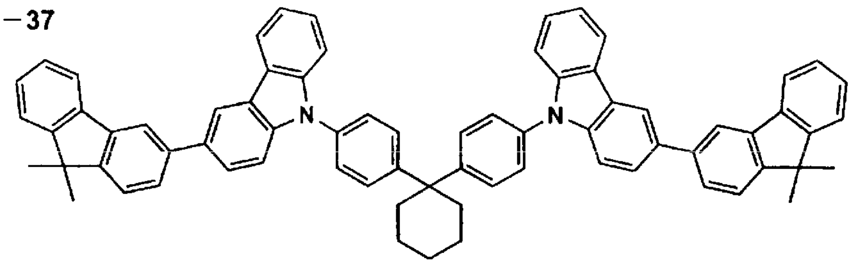

a−38

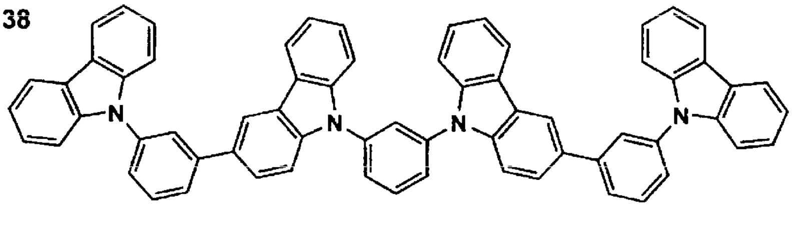

a−39

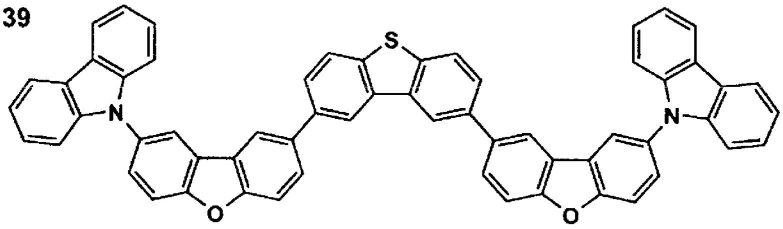

a−40

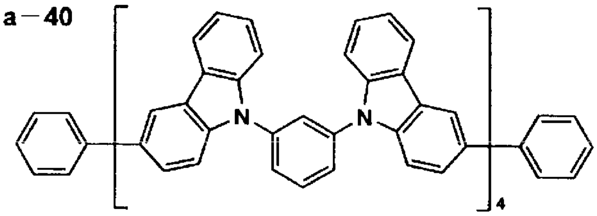

a−41

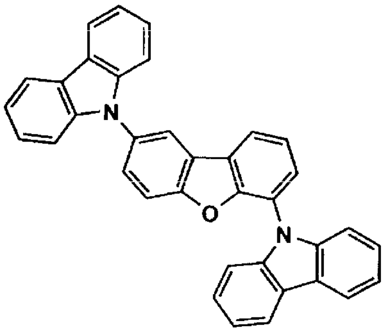

<<Anode 2>>

For the anode of the organic EL element of the present invention, a metal, alloy, electroconductive compound or a mixture thereof, each of which has a high work function (4 eV or more), is preferably used as an electrode material. Specific examples of the electrode material include metals such as Au and transparent electroconductive materials such as CuI, indium thin oxide (ITO), $SnO_2$ and ZnO. A material that is amorphous and can be used for a transparent electroconductive film such as IDIXO ($In_2O_3$-ZnO) may also be used. The anode may be obtained by forming a thin film with the above-described electrode material(s) by a method such as deposition or sputtering followed by patterning by photolithography to form a desired pattern. In the case where patterning does not need to be so accurate (about 100 μm or more), patterning may be conducted using a mask in a desired shape in deposition or sputtering of the above-described electrode material. In the case of using a compound that is appliable such as an organic electroconductive compound, a wet film forming method such as printing or coating may be used. For extracting emitted light from the anode, the transmittance of the anode is desirably 10% or more, and the sheet resistance of the anode is preferably a

few hundreds Ω/□ or less. The thickness of the layer normally ranges from 10 to 1000 nm, and preferably from 10 to 200 nm, while depending on its material.

<<Cathode 9>>

On the other hand, for the cathode of the organic EL element of the present invention, a metal, alloy, electroconductive compound or a mixture thereof, each of which has a low work function (4 eV or less) (called an electron-injecting metal) is preferably used as an electrode material. Examples of such an electrode material include sodium, sodium-potassium alloy, magnesium, lithium, a mixture of magnesium and copper, a mixture of magnesium and silver, a mixture of magnesium and aluminum, a mixture of magnesium and indium, a mixture of aluminum and aluminum oxide ($Al_2O_3$), indium, a mixture of lithium and aluminum and rare earth elements. Among them, in terms of electron-injecting properties and resistance against oxidation and the like, a preferable material is a mixture of an electron-injecting metal and a secondary metal that has work function higher than that of the electron-injecting material and is stable, for example, a mixture of magnesium and silver, a mixture of magnesium and aluminum, a mixture of magnesium and indium, a mixture of aluminum and aluminum oxide ($Al_2O_3$), a mixture of lithium and aluminum, aluminum and the like. The cathode may be obtained by forming a thin layer with the above-described electrode material(s) by a method such as deposition, sputtering or the like.
Sheet resistance of the cathode is preferably a few hundreds Ω/□ or less, and the thickness of the cathode is normally from 10 nm to 5 pm, and preferably from 50 to 200 nm.
To transmit emitted light, it is preferable that the anode or the cathode of the organic EL element is transparent or semi-transparent, which achieves improved luminance.
The transparent or semi-transparent cathode may be obtained by forming a layer having a thickness of 1 to 20 nm with the above-described metal (s) and subsequently applying the transparent electroconductive material(s) described in the description of the anode on the cathode; by using this procedure, an organic EL element including the anode and the cathode, both of which are transparent, are obtained.

<<Supporting substrate 1>>

Preferable examples of the transparent supporting substrate of the present invention include a glass substrate, a quartz substrate and a transparent resin film. A flexible substrate achieves effects for achieving storage stability in high temperature and suppressing change in chromaticity are achieved more greatly than a rigid substrate does. Thus, a particularly preferable supporting substrate is made from a resin film which is flexible and is capable of providing flexibility for an organic EL element.
Examples of the resin film include films of polyesters such as polyethylene terephthalate (PET) and polyethylene naphthalate (PEN), polyethylene, polypropylene, cellophane, cellulose esters and their derivatives such as cellulose diacetate, cellulose triacetate, cellulose acetate butyrate, cellulose acetate propionate (CAP), cellulose acetate phthalate (TAC) and cellulose nitrate, polyvinylidene chloride, polyvinyl alcohol, polyethylene vinyl alcohol, syndiotactic polystyrene, polycarbonate, norbornene resins, polymethylpentene, polyether ketones, polyimides, polyethersulfone (PES), polyphenylene sulfide, polysulfones, polyether imide, polyether ketone imide, polyamide, fluorine resins, nylon, polymethyl methacrylate, acrylics and polyarylates, and cycloolefin resins such as ARTON (trade name, manufactured by JSR Corp.) and APEL (trade name, manufactured by Mitsui Chemicals Inc.).
On the surface of the resin film, an inorganic or organic coating film or a hybrid coating film composed of the both may be formed. The coating film is preferably a high barrier film having a water vapor transmission rate at 25 ± 0.5°C and 90 ± 2% RH of 0.01 g/($m^2$·24h) or less determined according to JIS K 7129-1992, more preferably a high barrier film having an oxygen transmission rate of $10^{-3}$ $cm^3$/($m^2$·24h·atm) or less determined according to JIS K 7126-1987 and a water vapor transmission rate of $10^{-3}$ g/($m^2$·24h) or less. More preferably, the water vapor transmission rate is $10^{-5}$ g/($m^2$·24h) or less.
The barrier film may be formed with any material (s) that can prevent penetration of substances such as moisture and oxygen causing degradation of the element, and usable examples of the material include silicon oxide, silicon dioxide and silicon nitride. To improve weakness of the film, a barrier film having a laminate structure composed of an inorganic layer and an organic material layer is preferred. The order of these stacked inorganic layer(s) and organic layer(s) is not particularly limited, but it is preferable to stack the inorganic layers and organic layers alternately for multiple times.
The barrier film may be formed by any method without particular limitation. For example, vacuum deposition, sputtering, reactive sputtering, molecular beam epitaxy, ionized-cluster beam method, ion plating, plasma polymerization, atmospheric pressure plasma polymerization, plasma CVD, laser CVD, thermal CVD, or coating may be used, and atmospheric pressure plasma polymerization as described in Japanese Patent Application Laid-Open Publication No. 2004-68143 is preferable.
Examples of the opaque supporting substrate include metal plates such as an aluminum plate and stainless

plate, films, opaque resin substrates and ceramic substrates.

In the organic EL element of the present invention, efficiency of external extraction of light at room temperature is preferably 1% or more, and more preferably 5% or more. The efficiency of external extraction of light (%) is obtained by the equation:

efficiency of external extraction of light (%) = the number of photons emitted to the outside of an organic EL element/the number of electrons flowed into the organic EL element × 100

<<Sealing (Sealing Adhesive 10, Sealing member 11)>>

Examples of the sealing ways used in the present invention include a way of bonding a sealing member to the electrode and supporting substrate with an adhesive.

The sealing member is disposed so as to cover a display area composed of the organic EL element (s) and may be in a shape of concave plate or flat plate. The transparency and the electrical insulation properties thereof are not specifically limited.

Specific examples of the sealing member include a glass plate, a composite of polymer plate and film and a composite of metal plate and film. Particular examples of a glass plate include soda-lime grass plates, barium-strontium-containing glass plates, lead glass plates, aluminosilicate glass plates, borosilicate glass plates, barium borosilicate glass plates and quartz plates. Examples of a polymer plate include polycarbonate plates, acrylic plates, polyethylene terephthalate plates, polyethersulfide plates, polysulfone plates. Examples of a metal plate include plates composed of one or more types of metals selected from stainless, iron, copper, aluminum, magnesium, nickel, zinc, chromium, titanium, molybdenum, silicon, germanium and tantalum, and plates composed of an alloy(s) of the above metals.

In the present invention, in terms of providing a thin element, polymer films and metal films are preferable. A preferable polymer film has an oxygen transmission rate of $1\times10^{-3}$ $cm^3/(m^2\cdot day\cdot atm)$ or less determined according to JIS K 7126-1987 and a moisture vapor transmission rate at 25 ± 0.5°C and 90 ± 2% RH of $1\times10^{-3}$ $g/(m^2\cdot 24h)$ or less determined according to JIS K 7129-1992.

The sealing member may be made concave by sandblasting or chemical etching, for example.

The adhesive may be exemplified by light curing or heat curing adhesives containing reactive vinyl groups of an acrylic acid-based oligomer and/or methacrylic acid-based oligomer, moisture curing adhesives such as 2-cyanoacrylate, and heat and chemical curing adhesives (mixture of two types of adhesives) such as epoxy adhesives. In addition, hot-melt polyamides, hot-melt polyesters, hot-melt polyolefins, cationic UV curing epoxy resin adhesives may also be given as examples.

To prevent the organic EL element from being deteriorated by heat, preferable adhesives are curable at a temperature ranging from room temperature up to 80°C. In the adhesive, a desiccant may be dispersed. Application of the adhesive to a sealing area may be conducted using a commercially available dispenser or conducted by printing such as screen printing.

It is also preferable to form a layer as a sealing membrane including an inorganic or organic compound. The sealing membrane is formed on the electrode which sandwiches the organic layer with the supporting substrate so as to cover the electrode and the organic layer and so as to contact to the supporting substrate. A material used for the sealing membrane may be any materials capable of suppressing intrusion of matters that cause deterioration such as water, oxygen and the like. Examples of the material include silicon oxide, silicon dioxide, silicon nitride and the like. To improve weakness of the sealing membrane, the sealing membrane preferably has a laminated structure constituted of the inorganic layer composed of the above inorganic material (s) and an organic layer composed of an organic material (s). The sealing membrane may be formed by vacuum deposition, sputtering, reactive sputtering, molecular beam epitaxy, cluster ion beam, ion plating, plasma polymerization, atmospheric pressure plasma polymerization, plasma CVD, laser CVD, heat CVD or coating, but not specifically limited thereto.

Inert gas such as nitrogen and argon or inert liquid such as fluorohydrocarbon and silicone oil is preferably provided between the sealing member and the display area by injection to provide a gas or liquid medium between the sealing member and a display area composed of the organic EL element (s) . The gap between the sealing member and the display area may also be vacuum. Further, a hygroscopic compound may be enclosed within the gap. The hygroscopic compound may be exemplified by metal oxides such as sodium oxide, potassium oxide, calcium oxide, barium oxide, magnesium oxide, aluminum oxide; sulfates such as sodium sulfate, calcium sulfate, magnesium sulfate,

cobalt sulfate; metallic halides such as calcium chloride, magnesium chloride, cesium fluoride, tantalum fluoride, cerium bromide, magnesium bromide, barium iodide and magnesium iodide; perchloric acids such as barium perchlorate and magnesium perchlorate. As for sulfates, metallic halides and perchloric acids, anhydrous salts thereof are preferably used.

Sealing includes casing-type sealing and contacting-type sealing. In terms of providing a thin element, contacting-type sealing is preferable. To produce a flexible organic EL element, a sealing member is required to be flexible, and thus contacting-type sealing is preferable.

Preferred embodiments for contacting-type sealing will now be described.

The sealing adhesive used in the present invention may be, for example, a heat curable adhesive or UV curable resin, preferably a heat curable adhesive such as epoxy resin, acrylic resin or silicone resin, and more preferably an epoxy heat curable adhering resin which has excellent humid and water resistance and causes small shrinkage in curing.

The moisture content in the sealing adhesive used in the present invention is preferably 300 ppm or less, more preferably 0.01 to 200 ppm, and most preferably 0.01 to 100 ppm.

The moisture content referred herein may be measured by any method, for example, by using a volumetric titrator (Karl Fischer), an infrared moisture gauge, a microwave transmission moisture gauge, heating and drying gravimetry, GC/MS, IR, differential scanning calorimeter (DSC) or thermal desorption spectroscopy (TDS) . The moisture content of a film, solid film or the like may be obtained with rise in pressure caused by water evaporation using a precision moisture meter AVM-3000 manufactured by OMNITEK.

In the present invention, the moisture content of the sealing adhesive may be controlled by putting the sealing adhesive into a nitrogen atmosphere wherein the dew point is -80°C or less and the oxygen concentration is 0.08 ppm for a period adequately varied, or by drying the sealing adhesive by putting the sealing adhesive into vacuum at a pressure of less than 100 Pa for a period adequately varied. The sealing adhesive may be dried alone, or may be disposed on the sealing member and then dried together.

In the case of contacting-type sealing, as the sealing member, polyethylene terephthalate (PET) having a thickness of 50 μm on which an aluminum film having a thickness of 30 μm is formed is used. On the aluminum side of this sealing member, the sealing adhesive is uniformly applied using a dispenser, and then the resin substrate 1 is positioned with the sealing member 5. Thereafter, pressure bonding of the resin substrate 1 and the sealing member 5 is conducted (at a pressure of 0.1 to 3 MPa) and the resin substrate 1 and the sealing member 5 are adhered to each other at 80 to 180°C. Contacting-type sealing is thus conducted.

Periods for heating and pressure bonding vary according to, for example, a type of an adhesive, the amount of adhesive or an area for sealing, but heating and pressure bonding may be conducted in conditions of temporary adhesion at a pressure of 0.1 to 3 MPa, heating at a temperature of 80 to 180°C and heat curing for 5 seconds to 10 minutes.

It is preferable to use a heated pressure bonding roll because both heating and pressure bonding (temporary adhesion) can be simultaneously conducted and inner voids can be eliminated.

The layer of the adhesive may be formed by a coating method such as roll coating, spin coating, screen printing or spray coating, or printing, optionally using a dispenser according to a type of material.

Contacting-type sealing is covering with a cured resin causing no void between a sealing member and a substrate of an organic EL element. Examples of the sealing member include metals such as stainless, aluminum and magnesium alloy, plastics such as polyethylene terephthalate, polycarbonate, polystylene, nylon and polyvinyl chloride, composites thereof and glass. When needed, particularly in the case of using a resin film, a sealing member on which a gas barrier layer composed of aluminum, aluminum oxide, silicon oxide or silicon nitride is formed can be used, like the resin substrate described above. The gas barrier layer may be formed on the both or one surface of a sealing member by sputtering, deposition or the like before shaping the sealing member, or may be formed on the both or one surface of a sealing member by a method such as the above after sealing. This gas barrier layer preferably has an oxygen transmission rate of $1\times10^{-3}$ ml/($m^2$·24h·atm) or less and a water vapor transmission rate at 25 ± 0.5 °C and 90 ± 2% RH of $1\times10^{-3}$ g/($m^2$·24h) or less.

The sealing member may be a film on which a metal foil such as an aluminum foil is provided. To form a polymer film on one side of a metal foil, a commonly-used laminating device may be used. An adhesive may be a polyurethane adhesive, polyester adhesive, epoxy adhesive or acrylic adhesive. A curing agent may be used in combination with the adhesive as needed. Lamination may be conducted by hot-melt lamination, extrusion lamination or co-extrusion lamination, and dry lamination is preferable.

When a metal foil is formed by sputtering, deposition or the like with a fluid electrode material such as an electroconductive paste, the sealing member may formed by a way that is reverse to the above, namely, by forming a metal foil on a substrate of polymer film.

<<Protective Film, Protective Plate>>

A protective film or protective plate may be provided on the other side of the sealing membrane or sealing film, either of which is provided on the side sandwiching the organic functional layer with the supporting substrate, in order

to improve mechanical strength of the organic EL element. It is preferable to provide the protective film or protective plate especially in the case of sealing with the sealing membrane because the sealing membrane is not so mechanically strong. Materials for the protective film or protective plate may be exemplified by a glass plate, a composite of polymer plate and film and a composite of metal plate and film, like the materials for sealing. To achieve light weight and thinness, polymer film is preferable.

In the present invention, it is preferable to provide a light-extracting member between the flexible supporting substrate and the anode, or at any position from the flexible supporting substrate to a side from which light is extracted.

The light-extracting member may be exemplified by a prism sheet, lens sheet and diffusing sheet, and may also be exemplified by a diffracting grating or a diffusing structure provided in any medium or at an interface where total reflection occurs. Generally in the case of light emission from the side of a substrate of an organic electroluminescence element, part of light emitted from a light-emitting layer is totally reflected at the interface between a substrate and the air, resulted in loss of light. To solve this problem, the surface of the substrate is treated to form prism or lens structures, or a prism sheet, lens sheet or diffusing sheet is pasted on the surface of the substrate. Accordingly, total reflection is suppressed and efficiency of light extraction is improved.

To improve efficiency of light extraction, there is a known method for introducing a diffraction grating or a diffusing structure in any medium or at an interface where total reflection occurs.

<<Method for Evaluating Change in Color after Storage in High Temperature>>

An indicator of a change in color of an organic EL element, a step number of MacAdam ellipse (see *Shikisai Kougaku (Color Engineering)* written by Noboru OTA, for example).

A step number of MacAdam ellipse being 1 means that a color difference between two colors is at the limit of human capability of distinguishing two colors. As a step number increases, colors become easier to be distinguished.

A change in a color after a storage in high temperature can be evaluated with a step number between a color of an organic EL element before storage in high temperature and a color of the organic EL element after a storage at 85°C for 500 hours.

<<Method for Manufacturing Organic EL Element>>

As an example of the method for manufacturing the organic EL element of the present invention, a method for manufacturing an organic EL element composed of an anode/hole-injecting layer/hole-transporting layer/mixed layer/light-emitting layer/electron-transporting layer /electron-injecting layer/cathode will now be described.

The anode is obtained by forming a thin film having a thickness of 1 μm or less, preferably 10 to 200 nm and including a desired electrode material(s), for example, a material for the anode on a suitable substrate.

Subsequently, thin films each including organic compounds as materials of the organic EL element, i.e., the electron hole-injecting layer, the electron hole-transporting layer, the light-emitting layer, the electron hole-blocking layer, the electron-transporting layer and the electron-injecting layer, are formed on/over the anode.

Forming the organic functional layer is composed of: applying and stacking each application liquid for the organic functional layer on/over the anode on the supporting substrate; and drying each applied and stacked application liquid.

The applying and the drying may be conducted in the atmosphere. Preferably, the drying is conducted in an inert gas atmosphere such as a nitrogen atmosphere, and more preferably, the applying is also conducted in an inert gas atmosphere. The concentrations of water and oxygen in an inert gas atmosphere are each preferably 100 ppm or less, preferably 10 ppm or less, and more preferably 1 ppm or less.

A method for forming each layer is a wet process (such as spin coating, casting, die coating, blade coating, roll coating, ink jetting, printing, spray coating, curtain coating, Langmuir Blodgett (LB) method). At least the hole-injecting layer is formed by a wet process.

In forming layers of the organic functional layer other than the hole-injecting layer, a wet process is used for the present invention, because uniform layers can be formed and pinholes are hardly formed The wet process may be spin coating, casting, die coating, blade coating, roll coating and ink jetting.

Examples of a liquid medium dissolving or dispersing a material(s) for the organic EL element therein include ketones such as methylethyl ketone and cyclohexanone; aliphatic acid esters such as ethyl acetate; halogenated hydrocarbons such as dichlorobenzene; aromatic hydrocarbons such as toluene, xylene, mesitylene and cyclohexylbenzene; aliphatic hydrocarbons such as cyclohexane, decaline and dodecane; and organic solvents such as dimethyl formamide (DMF) and dimethyl sulfoxide (DMSO).

A method for dispersion may be, for example, ultrasonic wave dispersion, high shearing force dispersion or medium dispersion.

Preparation of a solution by dissolving or dispersing a material (s) for the organic EL element of the present

invention in a liquid medium is preferably conducted in an inert gas atmosphere, and preferably the solution is not exposed to an application atmosphere until the respective solutions are applied on/over the substrate by the above-described wet process.

The applying, the stacking and the drying the solutions may be conducted by single wafer production system or line production system.

An atmosphere for applying the solutions may be shared. In terms of effects by solvents that vaporize, it is preferable that booths for applying the respective solutions are enclosed with walls or the like and circulations of the atmospheres are independent to each other.

The drying may be conducted during conveyance on the line. In terms of productivity, the drying may be conducted after stacking or non-contact winding to form a roll.

In a preferred embodiment of the present invention, the temperature of the application liquid for forming the light-emitting layer and the temperature of the supporting substrate are adjusted to 40 to 60°C especially in the applying of the application liquid for forming the light-emitting layer to form the mixed layer having a thickness of 5 to 15 nm.

After the drying of these layers (application liquids), a thin film composed of a material (s) for the cathode is formed on the upper layer by, for example, vacuum deposition or sputtering so as to obtain a thickness of 1 μm or less, and preferably from 50 to 200 nm as the cathode.

Then, after drying with heat, the above-described contact-type sealing is performed, or sealing from the electrode to the supporting substrate with an adhesive is performed. An organic EL element to be obtained is thus manufactured.

<<Use Application>>

The organic EL element of the present invention may be used for display devices, displays and various light sources. Examples of light sources include various applications such as a lighting device (a household lighting and an in-car lighting, for example), a backlight of a clock or liquid crystal display, a billboard, a traffic signal, a light source of an optical storage medium, a light source of an electro photocopier, a light source of an optical communication processer, a light source of an optical sensor and a general electric home appliance which requires a display device. Particularly, the organic EL element of the present invention may be effectively used for a backlight of a liquid crystal display device combined with a color filter, or a light source for lighting.

In the organic EL element of the present invention, patterning may be conducted in forming a film using a metal mask or by inkjet printing method or the like as needed. Patterning may be conducted only for the electrode (s), for the electrodes and the light-emitting layer, or for all of the layers of the element. In manufacturing the element, any conventionally known method(s) may be used.

Example

The present invention will now be described with reference to an Example, but the present invention is not limited thereto. In the Example, "part(s)" and "%" indicate "part(s) by mass" and "% by mass", respectively, unless described otherwise.

<<Preparation of Sample (Organic EL Element>>

(1) Preparation of Organic EL Element 1

(Example not forming part of the invention)

As a flexible film, polyethylene naphthalate film (manufactured by Teijin DuPont Films Japan Limited, hereinafter abbreviated as PEN) was used. On the front surface of the side on which an anode was to be provided, a 500-nm-thick inorganic gas barrier film composed of SiOx was formed without intermission using an atmospheric pressure plasma discharge processor configured as described in Japanese Patent

Application Laid-open Publication No. 2004-68143. A flexible gas barrier film having an oxygen transmission rate of 0.001 ml/$m^2$/day or less and a water vapor transmission rate of 0.001 g/$m^2$/day or less was thus prepared.

(1.2) Formation of Anode

On the prepared flexible gas barrier film, a film having a thickness of 120 nm was formed with ITO (indium tin oxide) by sputtering, and then patterning was performed by photolithography. An anode was thus prepared. The formed pattern was formed to have a light-emitting area of 50 square millimeter.

(1.3) Formation of Hole-Injecting Layer

The patterned ITO substrate was washed by ultrasonic washing with isopropyl alcohol, dried in a dry nitrogen atmosphere, and then washed by UV ozone washing for 5 minutes. On this substrate, a film was formed with a 70% solution of poly(3,4-ethylenedioxythiophene)-polystylene sulfonate (abbreviated as PEDOT/PSS, Baytron P Al 4083 manufactured by Bayer AG) diluted with pure water by spin coating at 3000 rpm for 30 seconds. The formation of the film was conducted in the atmosphere. Thereafter, drying was conducted at 200°C for an hour. A hole-injecting layer having a thickness of 30 nm was thus prepared.

(1.4) Formation of Hole-Transporting Layer

The resulting substrate was put in a nitrogen atmosphere, and a film was formed thereon with a 0.5% solution of the exemplary compound (60) (Mw = 80,000), which is a hole-transporting material, in chlorobenzene by spin coating at 1500 rpm for 30 seconds, followed by drying at 130°C for 30 minutes. A hole-transporting layer having a thickness of 30 nm was thus prepared.

(1.5) Formation of Light-Emitting Layer

Subsequently, a film was formed with respective compounds for a light-emitting layer (i.e., an application liquid for forming a light-emitting layer) in the following composition ratio by spin coating at 1500 rpm for 30 seconds, followed by drying at 120 °C for 30 minutes. A light-emitting layer was thus prepared.
D-66 is a dopant emitting light of the shortest wavelength out of the light-emitting dopants used in the Example. A peak of intensity of emitted light is at a wavelength of 474 nm.
The light-emitting layer has a thickness of 38 nm when formed on a glass substrate by the way described above.

(Compound of Light-Emitting Layer)

| | |
|---|---|
| Non-light-emitting organic material (host compound); | |
| Exemplary compound a-1 | 10.69 parts by mass |
| Light-emitting dopant; | |
| Exemplary compound D-66 | 3.77 parts by mass |
| Exemplary compound D-67 | 0.022 part by mass |
| Exemplary compound D-80 | 0.022 part by mass |
| Solvent; | |
| Toluene | 2.00 parts by mass |

(1.6) Formation of Electron-Transporting Layer

Subsequently, a film was formed with a solution in which 20 mg of the exemplary compound represented by the general formula (A) (compound A) was dissolved in 4 ml of tetrafluoro propanol (TFPO) by spin coating at 1500 rpm for 30 seconds, followed by drying at 120°C for 30 minutes. An electron-transporting layer having a thickness of 30 nm was thus prepared.

[Chemical Formula 35]

Compound A

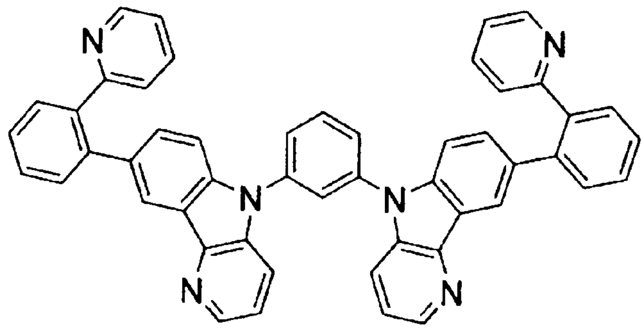

(1.7) Formation of Electron-Injecting Layer and Cathode

Thereafter, the resulting substrate was put in a vacuum deposition device without being exposed to the atmosphere. A molybdenum resistive heating boat in which potassium fluoride was placed was also put in the vacuum deposition device. Then the vacuum chamber was depressurized by $4\times10^{-5}$ Pa, and the boat was electrified to be heated so as to form an electron-injecting layer having a thickness of 2 nm with potassium fluoride at a rate of 0.02 nm/sec on the electron-transporting layer. Thereafter, aluminum was vapor-deposited so as to form a cathode having a thickness of 100 nm.

(1.8) Sealing and Preparation of Organic EL Element

Subsequently, a sealing member was adhered to the resulting substrate using a commercially-available roll lamination device to prepare an organic EL element 1 as a sample.
The sealing member used here was a 30-μm-thick flexible aluminum foil (manufactured by TOYO ALUMINIUM K.K.) on which a 12-μm-thick polyethylene terephthalate (PET) film was formed using an adhesive for dry lamination (a two-liquid reaction type urethane adhesive) (the thickness of the layer of the sealing adhesive was 1.5 μm).
On a side for adhesion (glossy side) of the aluminum foil, a heat curing adhesive as the sealing adhesive was uniformly applied using a dispenser to obtain a thickness of 20 μm, followed by drying in a vacuum at a pressure of 100 Pa or less for 12 hours. Thereafter, the resulting substrate was put in a nitrogen atmosphere where the dew point was -80°C and the oxygen concentration was 0.8 ppm, and was then dried for not less than 12 hours so as to adjust the moisture content in the sealing adhesive to 100 ppm or less.
The heat curing adhesive was an epoxy adhesive composed of a mixture of the following (A) to (C).

(A) bisphenol A diglycidyl ether (DGEBA)
(B) dicyandiamide (DICY)
(C) epoxy adduct curing accelerator

The resulting substrate to be sealed was arranged on and adhered to a junction of an extracting electrode and an electrode lead so as to cover the junction of the extracting electrode and the electrode lead, and the contacting-type sealing was conducted in the condition that the temperature of a pressure bonding roll was 120 °C, a pressure in bonding was 0.5 MPa and a rate of the device of 0.3 m/minute to form an element as illustrated in Fig. 1. The "organic EL element 1" was thus prepared.
The thickness of the mixed layer is measured by XPS using argon cluster ion sputtering. The element where layers up to the light-emitting layer was formed was subjected to this measurement. The thickness of the mixed layer of the organic EL element 1 was 4 nm.
(2) Preparation of Organic EL Elements 2 to 12 (Elements 2 to 6 and 13 are examples not forming part of the present invention, while elements 7 to 12 and 14 to 18 are inventive examples according to the present invention) Organic EL elements 2 to 12 were each prepared by the same way as the organic EL element 1 was prepared except that the temperatures of the substrate and the application liquid for forming the light-emitting layer, a mass concentration of the phosphorescent dopant D-66 in the light-emitting layer and the thickness of the light-emitting layer were changed as shown in Table 1.

The thickness of each light-emitting layer and the thickness of each mixed layer were measured by the same way as those of the organic EL element 1 were measured.

(3) Preparation of Organic EL Element 13

An organic EL element 13 was prepared by the same way as the organic EL element 1 was prepared except that the compounds for the light-emitting layer were changed to the compounds described below, and the temperatures of the substrate and the application liquid for forming the light-emitting layer and the mass concentration of the phosphorescent dopant D-66 in the light-emitting layer were changed as shown in Table 1.

The thickness of the light-emitting layer and the thickness of the mixed layer were measured by the same way as those of the organic EL element 1 were measured.

(Compound for Light-Emitting Layer)

Non-light-emitting organic material (host compound);
- Exemplary compound a-1 11.05 parts by mass
- Exemplary compound a-6 1.23 parts by mass

Light-emitting dopant;
- Exemplary compound D-66 2.18 parts by mass
- Exemplary compound D-67 0.025 part by mass
- Exemplary compound D-80 0.025 part by mass

Solvent;
- Toluene 2.000 parts by mass

(4) Preparation of Organic EL Elements 14 to 18

Organic EL elements 14 to 18 were each prepared by the same way as the organic EL element 1 was prepared except that the temperatures of the substrate and the application liquid for forming the light-emitting layer, the mass concentration of the phosphorescent dopant D-66 in the light-emitting layer and the thickness of the light-emitting layer were changed as shown in Table 1.

The thickness of the light-emitting layer and the thickness of the mixed layer were measured by the same way as those of the organic EL element 1 were measured.

[Table 1]

| Sample (Organic Element | Host In Light-Emitting Layer | Temperatures of Substrate and Application Liquid [°C] | Thickness of Mixed Layer [nm] | Concentration Phospbrescent Dopant [% by mass] | Thickness of Light-Emitting Layer [nm] | Note |
|---|---|---|---|---|---|---|
| 1 | a-1 | 25 | 4 | 25 | 40 | Comparative Example |
| 2 | a-1 | 25 | 4 | 21 | 40 | |
| 3 | a-1 | 25 | 4 | 15 | 40 | |
| 4 | | | | | 60 | |
| 5 | | | | | 80 | |

(continued)

| Sample (Organic Element | Host In Light-Emitting Layer | Temperatures of Substrate and Application Liquid [°C] | Thickness of Mixed Layer [nm] | Concentration Phospbrescent Dopant [% by mass] | Thickness of Light-Emitting Layer [nm] | Note |
|---|---|---|---|---|---|---|
| 6 | a-1 | 40 | 7 | 15 | 40 | Example |
| 7 | | | | | 60 | |
| 8 | | | | | 80 | |
| 9 | | | | | 100 | |
| 10 | a-1 | 60 | 15 | 15 | 60 | |
| 11 | | | | | 80 | |
| 12 | | | | | 100 | |
| 13 | a-1:a-6=9:1 (mass ratio) | 40 | 7 | 15 | 40 | |
| 14 | a-1 | 40 | 7 | 15 | 60 | |
| 15 | | | | | 80 | |
| 16 | a-1 | 40 | 7 | 25 | 60 | |
| 17 | | | | 21 | | |
| 18 | a-1 | 60 | 15 | 15 | 100 | |

Note that in Table 1 Sample (Organic EL Element) 6 and 13 are examples not forming part of the present invention, since they do not satisfy the relation

$$5t_{mix} + 25 \leq t_{EML} \leq 5t_{mix} + 45.$$

<<Evaluation of Sample (Organic EL Element)>>

The organic EL elements 1 to 18 were evaluated for each of the following points.

(1) Evaluation of Voltage

Power efficiencies (lm/W) of the respective organic EL elements to which a constant current of 2.5 mA/cm$^2$ was applied were measured with a spectroradiometer CS-2000 (manufactured by Konica Minolta Sensing Inc.). The power efficiencies of the organic EL elements 1 to 18 were each described in a relative value defining power efficiency of the organic EL element 1 (a comparative example) as 100. Results of the evaluation are shown in Table 2. A Higher value indicates that the voltage was lower.

(2) Evaluation for Stability in Continuous Driving (Lifetime)

Each of the organic EL elements was put on a cylinder with a radius of 5 cm so that the organic EL element was bent, and the bent organic EL element was continuously driven. Luminance of each bent organic EL element was measured with a spectroradiometer CS-2000 (manufactured by Konica Minolta Sensing Inc.). A time period until the luminance decreased by half (LT50) was obtained. The driving was conducted in the condition that a current had a value of 4000 cd/m$^2$ at the start of the continuous driving.

Relative values of LT50s of the organic EL elements were calculated defining the LT50 of the organic EL element 1 (comparative example) as 100. These relative values were indicators of stability in continuous driving (lifetime). A higher value indicated that a lifetime is longer (i.e., improvement is achieved more largely).

(3) Evaluation for Stability in Storage in High Temperature

Each of the organic EL elements was put on a cylinder with a radius of 5 cm so that the organic EL element was bent. Chromaticity of each bend organic EL element to which a constant current of 2.5 mA/$cm^2$ was applied was measured (an initial state) . The cylinders each having the bent organic EL element thereon were then put and kept in a thermostatic chamber at 85°C for 500 hours. Subsequently, the cylinders each having the bent organic EL element thereon were taken out from the thermostatic chamber, and chromaticity of each bent organic EL element to which a constant current of 2.5 mA/$cm^2$ applied was measured (a state after a storage in high temperature).

A change in a color before and after the storage in high temperature was represented by a step number of MacAdam ellipse. Results from the evaluation are shown in Table 2. A lower value indicates that a change in a color is smaller.

[Table 2]

| Sample (Organic EL Element) | Voltage | Lifetime | Step Number, Change in Color after Storage in High Temperature | Note |
|---|---|---|---|---|
| 1 | 100 | 100 | 11 | Comparative Example |
| 2 | 100 | 100 | | |
| 3 | 100 | 100 | | |
| 4 | 130 | 110 | | |
| 5 | 150 | 120 | | |
| 6 | 85 | 110 | 8 | Example |
| 7 | 90 | 120 | | |
| 8 | 95 | 130 | | |
| 9 | 98 | 140 | | |
| 10 | 80 | 120 | 5 | |
| 11 | 90 | 130 | | |
| 12 | 95 | 140 | | |
| 13 | 80 | 110 | 8 | |
| 14 | 87 | 130 | | |
| 15 | 92 | 135 | | |
| 16 | 87 | 102 | | |
| 17 | 87 | 106 | | |
| 18 | 95 | 145 | 5 | |

Note that in Table 2 Sample (Organic EL Element) 6 and 13 are examples not forming part of the present invention, since they do not satisfy the relation 5tmix + 25 ≤ tEML ≤ 5tmix + 45.

(4) Conclusion

As shown in Table 2, the organic EL elements 7 to 12 and 14 to 18 according to the Example of the present invention each require a low voltage, achieve a long lifetime and cause a small change in a color after a storage in high temperature, compared to the organic EL elements 1 to 6 and 13. Therefore, an element that includes the mixed layer having a thickness of 5 to 15 nm and wherein the thickness of the mixed region $t_{mix}$ and the thickness of the light-emitting layer $t_{EML}$ satisfy a relation expressed by $5t_{mix} + 25 \leq t_{EML} \leq 5t_{mix} + 45$, and uses a dopant(s) which constitute the light-emitting layer, the dopant(s) having a peak of intensity of emitted light at 500 nm or less, can be effectively used to achieve a high power efficiency by virtue of low voltage and excellent stability in a long-term driving and to suppress a change in a color after a storage in high temperature.

Industrial Applicability

The present invention can be suitably used for achieving a high power efficiency by virtue of low voltage, improving stability in a long-term driving and improving stability in a storage in high temperature.

Description of Reference Numeral

1 Flexible supporting substrate
2 Anode
3 Hole-injecting layer
4 Hole-transporting layer
5 Mixed layer
6 Light-emitting layer
7 Electron-transporting layer
8 Electron-injecting layer
9 Cathode
10 Sealing adhesive
11 Flexible sealing member
20 Organic functional layer
100 Organic electroluminescent element (Organic EL element)

## Claims

**1.** A method of manufacturing an organic electroluminescent element (100) comprising:

at least four organic functional layers (20) between an anode (2) and a cathode (9), wherein
two of the at least four organic functional layers (20) are a hole-transporting layer (4) and a light-emitting layer (6),
a 5 to 15-nm mixed region (5) is provided between the hole-transporting layer (4) and the light-emitting layer (6), the mixed region (5) comprising both of a material which constitutes the hole-transporting layer and a material which constitutes the light-emitting layer,
the light-emitting layer (6) comprises one or more phosphorescent dopants, and
a peak of intensity of light emitted from a phosphorescent dopant which emits light of a shortest wavelength out of the phosphorescent dopants in the light-emitting layer is at 500 nm or less, and
a thickness of the mixed region (5) $t_{mix}$ and the thickness of the light-emitting layer (6) $t_{EML}$ satisfy a relation expressed by $5t_{mix} + 25 \leq t_{EML} \leq 5t_{mix} + 45$, wherein a unit of the thickness of the light-emitting layer (6) is nanometer, the method comprising:

forming the at least four organic functional layers (20) by a wet process application method.

**2.** The method of manufacturing the organic electroluminescent element (100) of claim 1, wherein a content of the one or more phosphorescent dopants contained in the light-emitting layer (6) is 3 to 25% by mass.

**3.** The method of manufacturing the organic electroluminescent element (100) of claim 1 or 2, wherein a thickness of the light-emitting layer (6) is 50 to 100 nm.

**4.** The method of manufacturing the organic electroluminescent element (100) of any one of claims 1 to 3, wherein the light-emitting layer (6) comprises two or more host compounds.

**5.** The method of manufacturing the organic electroluminescent element (100) of any one of claims 1 to 4, wherein at least one of the one or more phosphorescent dopants contained in the light-emitting layer (6) is represented by a following general formula (1):

[Chemical Formula 1]

General formula (1)

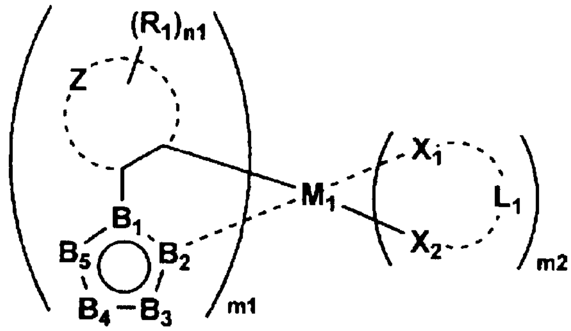

wherein R1 represents a substituent; Z represents a group of non-metal atoms necessary for forming a five to seven-membered ring; n1 represents an integer from 0 to 5; B1 to B5 each represent a carbon atom, a nitrogen atom, an oxygen atom or a sulfur atom and at least one of B1 to B5 represents a nitrogen atom; M1 represents a transition metal element of Groups 8 to 10 of the periodic table; X1 and X2 each represent a carbon atom, a nitrogen atom or an oxygen atom; L1 represents a group of atoms forming a bidentate ligand together with X1 and X2; m1 represents an integer 1, 2 or 3; m2 represents an integer 0, 1 or 2; and m1 + m2 is equal to 2 or 3.

**6.** The method of manufacturing the organic electroluminescent element (100) of any one of claims 1 to 5, wherein at least one of the host compounds contained in the light-emitting layer (6) is represented by a following general formula (2)

[Chemical Formula 2]

General formula (2)

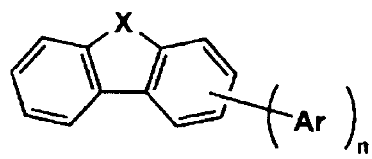

wherein X represents NR', O, S, CR'R" or SiR'R"; R' and R" each represent a hydrogen atom or a substituent; Ar represents an aromatic ring; and n represents an integer from 0 to 8.

**7.** The method of manufacturing the organic electroluminescent element (100) of any one of claims 1 to 6, wherein the hole-transporting layer (4) consists of a polymer whose main chain is made of triphenylamine.

**8.** The method of manufacturing the organic electroluminescent element (100) of any one of claims 1 to 7, wherein a weight-average molecule weight of a polymer contained in the hole-transporting layer (4) is 60,000 to 100,000.

**9.** The method of manufacturing the organic electroluminescent element (100) according to any one of claims 1 to 8, further comprising:

forming the mixed region (5) by the sequential steps of

(i) forming the hole-transporting layer (4) by a wet process application method, and
(ii) forming the light-emitting layer (6) on the hole-transporting layer (4) by a wet process application method.

**10.** An organic electroluminescent element (100) comprising:

at least four organic functional layers (20) between an anode (2) and a cathode (9), wherein
two of the at least four organic functional layers (20) are a hole-transporting layer (4) and a light-emitting layer (6),
a 5 to 15-nm mixed region (5) is provided between the hole-transporting layer (4) and the light-emitting layer (6), the mixed region (5) comprising both of a material which constitutes the hole-transporting layer and a material which constitutes the light-emitting layer,
the light-emitting layer (6) comprises one or more phosphorescent dopants, and
a peak of intensity of light emitted from a phosphorescent dopant which emits light of a shortest wavelength out of the phosphorescent dopants in the light-emitting layer is at 500 nm or less,
a weight-average molecule weight of a polymer contained in the hole-transporting layer (4) is 60,000 to 100,000, and
a thickness of the mixed region (5) $t_{mix}$ and the thickness of the light-emitting layer (6) $t_{EML}$ satisfy a relation expressed by $5t_{mix} + 25 \leq t_{EML} \leq 5t_{mix} + 45$, wherein a unit of the thickness of the light-emitting layer (6) is nanometer.

## Patentansprüche

1. Verfahren zur Herstellung eines organischen elektrolumineszierenden Elements (100), das Folgendes umfasst:

mindestens vier organische funktionale Schichten (20) zwischen einer Anode (2) und einer Kathode (9), wobei
zwei der mindestens vier organischen funktionalen Schichten (20) eine lochtransportierende Schicht (4) und eine lichtemittierende Schicht (6) sind,
ein 5- bis 15-nm-Mischbereich (5) zwischen der lochtransportierenden Schicht (4) und der lichtemittierenden Schicht (6) bereitgestellt ist, wobei der Mischbereich (5) sowohl einen Stoff, der die lochtransportierende Schicht ausmacht, als auch einen Stoff, der die lichtemittierende Schicht ausmacht, umfasst,
die lichtemittierende Schicht (6) einen oder mehrere phosphoreszierende Dotierstoffe umfasst, und
ein Peak der Intensität des Lichts, das von einem phosphoreszierenden Dotierstoff emittiert wird, der Licht einer kürzesten Wellenlänge von den phosphoreszierenden Dotierstoffen in der lichtemittierenden Schicht emittiert, bei 500 nm oder weniger liegt, und
eine Dicke des Mischbereichs (5) $t_{mix}$ und die Dicke der lichtemittierenden Schicht (6) $t_{EML}$ eine Beziehung erfüllen, die durch $5t_{mix} + 25 \leq t_{EML} \leq 5t_{mix} + 45$ ausgedrückt wird, wobei eine Einheit der Dicke der lichtemittierenden Schicht (6) Nanometer ist,

wobei das Verfahren Folgendes umfasst:

Bilden der mindestens vier organischen funktionalen Schichten (20) durch ein Nassprozess-Auftragungsverfahren.

2. Verfahren zur Herstellung des organischen elektrolumineszierenden Elements (100) nach Anspruch 1, wobei ein Gehalt an dem einen oder den mehreren phosphoreszierenden Dotierstoffen, die in der lichtemittierenden Schicht (6) enthalten sind, 3 bis 25 Masse-% beträgt.

3. Verfahren zur Herstellung des organischen elektrolumineszierenden Elements (100) nach Anspruch 1 oder 2, wobei eine Dicke der lichtemittierenden Schicht (6) 50 bis 100 nm beträgt.

4. Verfahren zur Herstellung des organischen elektrolumineszierenden Elements (100) nach einem der Ansprüche 1 bis 3, wobei
die lichtemittierende Schicht (6) zwei oder mehr Wirtsverbindungen umfasst.

5. Verfahren zur Herstellung des organischen elektrolumineszierenden Elements (100) nach einem der Ansprüche 1 bis 4, wobei
mindestens einer des einen oder der mehreren phosphoreszierenden Dotierstoffe, die in der lichtemittierenden Schicht (6) enthalten sind, durch eine folgende allgemeine Formel (1) dargestellt wird:

[Chemische Formel 1]

Allgemeine Formel (1)

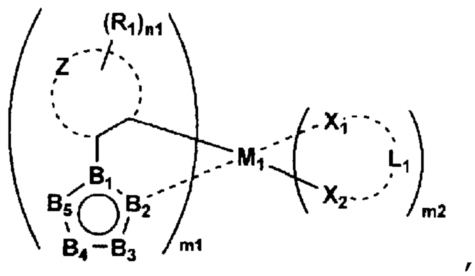

wobei R1 einen Substituenten darstellt; Z eine Gruppe von Nichtmetallatomen darstellt, die für die Bildung eines fünf- bis siebengliedrigen Rings notwendig sind; n1 eine ganze Zahl von 0 bis 5 darstellt; B1 bis B5 jeweils ein Kohlenstoffatom, ein Stickstoffatom, ein Sauerstoffatom oder ein Schwefelatom darstellen und mindestens eines von B1 bis B5 ein Stickstoffatom darstellt; M1 ein Übergangsmetallelement der Gruppen 8 bis 10 des Periodensystems darstellt; X1 und X2 jeweils ein Kohlenstoffatom, ein Stickstoffatom oder ein Sauerstoffatom darstellen; L1 eine Gruppe von Atomen darstellt, die zusammen mit X1 und X2 einen zweizähnigen Liganden bilden; m1 eine ganze Zahl 1, 2 oder 3 darstellt; m2 eine ganze Zahl 0, 1 oder 2 darstellt; und m1 + m2 gleich 2 oder 3 ist.

**6.** Verfahren zur Herstellung des organischen elektrolumineszierenden Elements (100) nach einem der Ansprüche 1 bis 5, wobei
mindestens eine der Wirtsverbindungen, die in der lichtemittierenden Schicht (6) enthalten sind, durch eine folgende allgemeine Formel (2) dargestellt wird:

[Chemische Formel 2]

Allgemeine Formel (2)

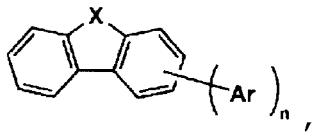

wobei X NR', O, S, CR'R" oder SiR'R" darstellt; R' und R" jeweils ein Wasserstoffatom oder einen Substituenten darstellen; Ar einen aromatischen Ring darstellt; und n eine ganze Zahl von 0 bis 8 darstellt.

**7.** Verfahren zur Herstellung des organischen elektrolumineszierenden Elements (100) nach einem der Ansprüche 1 bis 6, wobei
die lochtransportierende Schicht (4) aus einem Polymer besteht, dessen Hauptkette aus Triphenylamin erzeugt wurde.

**8.** Verfahren zur Herstellung des organischen elektrolumineszierenden Elements (100) nach einem der Ansprüche 1 bis 7, wobei
ein gewichtsmittleres Molekulargewicht eines Polymers, das in der lochtransportierenden Schicht (4) enthalten ist, 60 000 bis 100 000 beträgt.

**9.** Verfahren zur Herstellung des organischen elektrolumineszierenden Elements (100) nach einem der Ansprüche 1 bis 8, das weiter Folgendes umfasst:

Bilden des Mischbereichs (5) durch die aufeinanderfolgenden Schritte von

(i) Bilden der lochtransportierenden Schicht (4) durch ein Nassprozess-Auftragungsverfahren und
(ii) Bilden der lichtemittierenden Schicht (6) auf der lochtransportierenden Schicht (4) durch ein Nassprozess-Auftragungsverfahren.

**10.** Organisches elektrolumineszierendes Element (100), das Folgendes umfasst:

mindestens vier organische funktionale Schichten (20) zwischen einer Anode (2) und einer Kathode (9), wobei zwei der mindestens vier organischen funktionalen Schichten (20) eine lochtransportierende Schicht (4) und

eine lichtemittierende Schicht (6) sind,
ein 5- bis 15-nm-Mischbereich (5) zwischen der lochtransportierenden Schicht (4) und der lichtemittierenden Schicht (6) bereitgestellt ist, wobei der Mischbereich (5) sowohl einen Stoff, der die lochtransportierende Schicht ausmacht, als auch einen Stoff, der die lichtemittierende Schicht ausmacht, umfasst,
die lichtemittierende Schicht (6) einen oder mehrere phosphoreszierende Dotierstoffe umfasst, und
ein Peak der Intensität des Lichts, das von einem phosphoreszierenden Dotierstoff emittiert wird, der Licht einer kürzesten Wellenlänge von den phosphoreszierenden Dotierstoffen in der lichtemittierenden Schicht emittiert, bei 500 nm oder weniger liegt,
ein gewichtsmittleres Molekulargewicht eines Polymers, das in der lochtransportierenden Schicht (4) enthalten ist, 60 000 bis 100 000 beträgt, und
eine Dicke des Mischbereichs (5) $t_{mix}$ und die Dicke der lichtemittierenden Schicht (6) $t_{EML}$ eine Beziehung erfüllen, die durch $5t_{mix} + 25 \leq t_{EML} \leq 5t_{mix} + 45$ ausgedrückt wird, wobei eine Einheit der Dicke der lichtemittierenden Schicht (6) Nanometer ist.

## Revendications

1. Procédé de fabrication d'un élément électroluminescent organique (100) comprenant :

   au moins quatre couches fonctionnelles organiques (20) entre une anode (2) et une cathode (9), dans lesquelles deux desdites au moins quatre couches fonctionnelles organiques (20) sont une couche de transport de trous (4) et une couche d'émission de lumière (6),
   une région mixte (5) de 5 à 15 nm est prévue entre la couche de transport de trous (4) et la couche d'émission de lumière (6), la région mixte (5) comprenant à la fois un matériau qui constitue la couche de transport de trous et un matériau qui constitue la couche d'émission de lumière,
   la couche d'émission de lumière (6) comprend un ou plusieurs agents dopants phosphorescents, et
   un pic d'intensité de lumière émise depuis un agent dopant phosphorescent qui émet la lumière ayant la longueur d'onde la plus courte parmi les agents dopants phosphorescents dans la couche d'émission de lumière se trouve à 500 nm ou moins, et
   l'épaisseur $t_{mix}$ de la région mixte (5) et l'épaisseur $t_{EML}$ de la couche d'émission de lumière (6) satisfont une relation exprimée par $5t_{mix} + 25 \leq t_{EML} \leq 5t_{mix} + 45$, l'unité d'épaisseur de la couche d'émission de lumière (6) étant le nanomètre,
   ledit procédé comprenant :

   la formation desdites au moins quatre couches fonctionnelles organiques (20) par un procédé de dépôt par voie humide.

2. Procédé de fabrication de l'élément électroluminescent organique (100) selon la revendication 1, dans lequel
   la teneur desdits un ou plusieurs agents dopants phosphorescents contenus dans la couche d'émission de lumière (6) va de 3 à 25 % en masse.

3. Procédé de fabrication de l'élément électroluminescent organique (100) selon la revendication 1 ou la revendication 2, dans lequel l'épaisseur de la couche d'émission de lumière (6) va de 50 à 100 nm.

4. Procédé de fabrication de l'élément électroluminescent organique (100) selon l'une quelconque des revendications 1 à 3, dans lequel
   la couche d'émission de lumière (6) comprend deux ou plus de deux composés hôtes.

5. Procédé de fabrication de l'élément électroluminescent organique (100) selon l'une quelconque des revendications 1 à 4, dans lequel
   l'un au moins desdits un ou plusieurs agents dopants phosphorescents contenus dans la couche d'émission de lumière (6) est représenté par une formule générale (1) suivante :

[Formule chimique 1]

Formule générale (1)

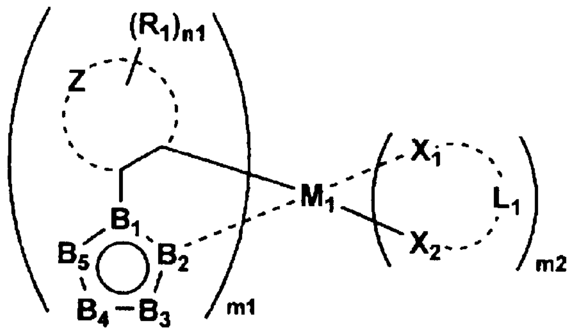

où R1 représente un substituant ; Z représente un groupe d'atomes non métalliques nécessaires pour former un noyau cyclique de cinq à sept éléments ; n1 représente un nombre entier valant de 0 à 5 ; B1 à B5 représentent chacun un atome de carbone, un atome d'azote, un atome d'oxygène ou un atome de soufre et l'un au moins parmi B1 à B5 représente un atome d'azote ; M1 représente un métal de transition des groupes 8 à 10 de la classification périodique des éléments ; X1 et X2 représentent chacun un atome de carbone, un atome d'azote ou un atome d'oxygène ; L1 représente un groupe d'atomes formant un ligand bidentate conjointement avec X1 et X2 ; m1 représente un nombre entier valant 1, 2 ou 3 ; m2 représente un nombre entier valant 0, 1 ou 2 ; et m1 + m2 est égal à 2 ou 3.

**6.** Procédé de fabrication de l'élément électroluminescent organique (100) selon l'une quelconque des revendications 1 à 5, dans lequel
l'un au moins des composés hôtes contenus dans la couche d'émission de lumière (6) est représenté par une formule générale (2) suivante

[Formule chimique 2]

Formule générale (2)

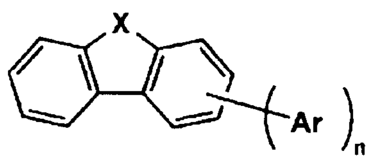

où X représente NR', O, S, CR'R" ou SiR'R" ; R' et R" représentent chacun un atome d'hydrogène ou un substituant ; Ar représente un noyau aromatique ; et n représente un nombre entier valant de 0 à 8.

**7.** Procédé de fabrication de l'élément électroluminescent organique (100) selon l'une quelconque des revendications 1 à 6, dans lequel
la couche de transport de trous (4) est constituée d'un polymère dont la chaîne principale est faite de triphénylamine.

**8.** Procédé de fabrication de l'élément électroluminescent organique (100) selon l'une quelconque des revendications 1 à 7, dans lequel
une masse moléculaire moyenne en poids d'un polymère contenu dans la couche de transport de trous (4) va de 60 000 à 100 000.

**9.** Procédé de fabrication de l'élément électroluminescent organique (100) selon l'une quelconque des revendications 1 à 8, comprenant en outre :

la formation de la région mixte (5) par les étapes séquentielles consistant à

(i) former la couche de transport de trous (4) par un procédé de dépôt par voie humide, et
(ii) former la couche d'émission de lumière (6) sur la couche de transport de trous (4) par un procédé de dépôt par voie humide.

**10.** Élément électroluminescent organique (100) comprenant :

au moins quatre couches fonctionnelles organiques (20) entre une anode (2) et une cathode (9), dans lesquelles deux desdites au moins quatre couches fonctionnelles organiques (20) sont une couche de transport de trous (4) et une couche d'émission de lumière (6),
une région mixte (5) de 5 à 15 nm est prévue entre la couche de transport de trous (4) et la couche d'émission de lumière (6), la région mixte (5) comprenant à la fois un matériau qui constitue la couche de transport de trous et un matériau qui constitue la couche d'émission de lumière,
la couche d'émission de lumière (6) comprend un ou plusieurs agents dopants phosphorescents, et
un pic d'intensité de lumière émise depuis un agent dopant phosphorescent qui émet la lumière ayant la longueur d'onde la plus courte parmi les agents dopants phosphorescents dans la couche d'émission de lumière se trouve à 500 nm ou moins,
une masse moléculaire moyenne en poids d'un polymère contenu dans la couche de transport de trous (4) va de 60 000 à 100 000, et
une épaisseur $t_{mix}$ de la région mixte (5) et l'épaisseur $t_{EML}$ de la couche d'émission de lumière (6) satisfont une relation exprimée par $5t_{mix} + 25 \leq t_{EML} \leq 5t_{mix} + 45$, une unité d'épaisseur de la couche d'émission de lumière (6) étant le nanomètre.

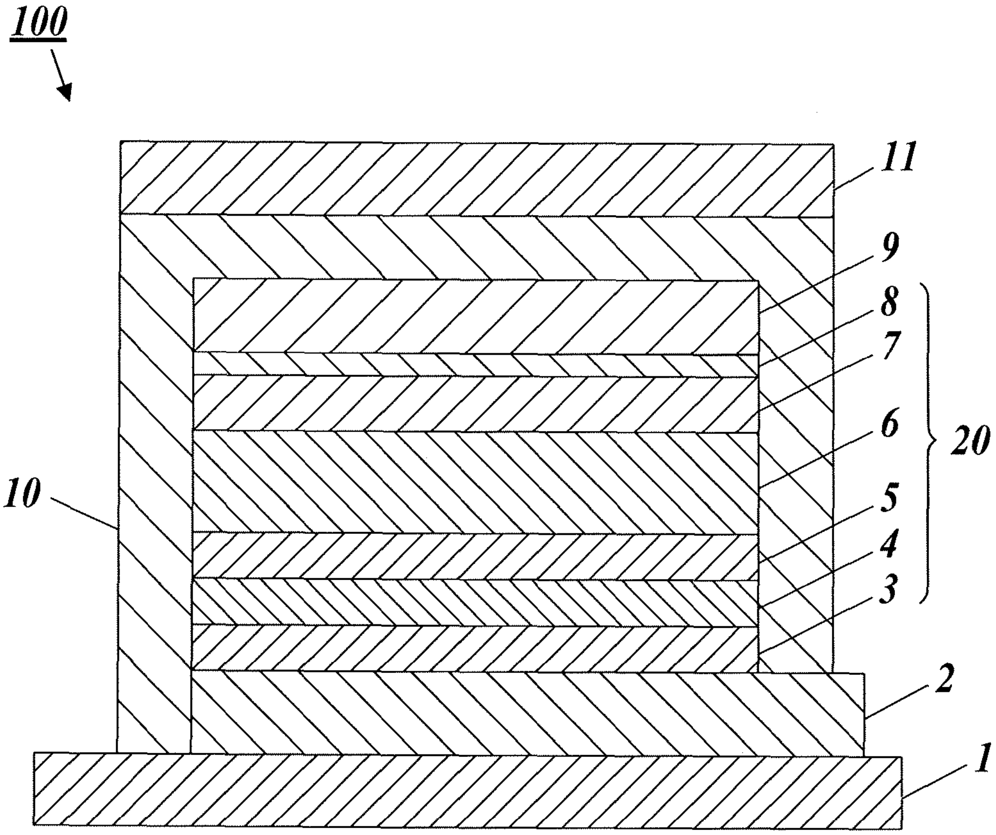
100
11
9
8
7
6
20
10
5
4
3
2
1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 1220339 A
- US 2011068331 A
- WO 2008065975 A
- JP 2008235327 A
- JP 2010067960 A
- JP 2007042314 A
- JP HEI945479 B
- JP HEI9260062 A
- JP HEI8288069 A
- JP HEI6325871 B
- JP HEI917574 A
- JP HEI1074586 A
- US 5061569 A
- JP HEI4308688 B
- JP HEI4297076 B
- JP 2000196140 A
- JP 2001102175 A
- JP HEI11251067 B
- JP 2003519432 A
- JP HEI10270172 A
- JP 2001257076 A
- JP 2002308855 A
- JP 2001313179 A
- JP 2002319491 A
- JP 2001357977 A
- JP 2002334786 A
- JP 2002008860 A
- JP 2002334787 A
- JP 2002015871 A
- JP 2002334788 A
- JP 2002043056 A
- JP 2002334789 A
- JP 2002075645 A
- JP 2002338579 A
- JP 2002105445 A
- JP 2002343568 A
- JP 2002141173 A
- JP 2002352957 A
- JP 2002203683 A
- JP 2002363227 A
- JP 2002231453 A
- JP 2003003165 A
- JP 2002234888 A
- JP 2003027048 A
- JP 2002255934 A
- JP 2002260861 A
- JP 2002280183 A
- JP 2002299060 A
- JP 2002302516 A
- JP 2002305083 A
- JP 2002305084 A
- JP 2002308837 A
- JP 2004068143 A


### Non-patent literature cited in the description


- **LIAN DUAN et al.** Solution processable small molecules for organic light-emitting diodes. *Journal of Materials Chemistry,* 01 January 2010, vol. 20 (31), 6392
- **BELLMANN et al.** New triarylamine-containing polymers as hole transport materials... *Chem. Mater.,* 1998, vol. 10, 1668-1676
- Electrode Materials. Organic EL element and its frontier of industrialization. NTS Corporation, 30 November 1998, 123-166
- *J. Appl. Phys.,* 2004, vol. 95, 5773
- **J. HUANG et al.** *Applied Physics Letters,* 2002, vol. 80, 139
- *Makromol. Chem.,* 1992, vol. 193, 909
- Experimental Chemistry 7. Spectroscopy II. MARUZEN Co., Ltd, 1992, 398